# EUROPEAN PATENT APPLICATION

(11) **EP 3 451 402 A1**
(43) Date of publication of application: **06.03.2019**
(21) Application number: 17789309.6
(22) Date of filing: 14.04.2017
(51) Int. Cl.: H01L 51/50, C08G 61/12, C09D 11/00

(54) **CHARGE TRANSPORT MATERIAL AND UTILIZATION THEREOF**

(30) Priority: 28.04.2016 JP 2016091113; 07.11.2016 WO PCT/JP2016/082991; 02.03.2017 JP 2017039341; 15.03.2017 JP 2017050056
(71) Applicant: Hitachi Chemical Company, Ltd., Chiyoda-ku Tokyo 100-6606 (JP)
(72) Inventor: KAMO Kazuyuki, Tokyo 100-6606 (JP); ASANO Naoki, Tokyo 100-6606 (JP); TAKAIRA Hiroshi, Tokyo 100-6606 (JP); FUKUSHIMA Iori, Tokyo 100-6606 (JP); FUNYUU Shigeaki, Tokyo 100-6606 (JP)
(74) Representative: Hoffmann Eitle
(86) International application number: PCT/JP2017/015242
(87) International publication number: WO 2017/188023

(57) **Abstract**

A charge transport material containing a charge transport compound for which the thermal weight reduction upon heating at 300°C is not more than 5% by mass. The charge transport material has resistance to high-temperature processes, and can be used in organic electronic elements.

## Description

### TECHNICAL FIELD

Embodiments of the present invention relate to a charge transport material, and an ink composition that uses the material. Further, other embodiments of the present invention relate to an organic layer that uses the charge transport material or the ink composition, and an organic electronic element, an organic electroluminescent element, a display element, an illumination device and a display device that each include the organic layer.

### BACKGROUND ART

Organic electronic elements are elements which use an organic substance to perform an electrical operation, and because they are expected to be capable of providing advantages such as low energy consumption, low prices and superior flexibility, they are attracting considerable attention as a potential alternative technology to conventional inorganic semiconductors containing mainly silicon.

Examples of organic electronic elements include organic electroluminescent elements (hereafter also referred to as "organic EL elements"), organic photoelectric conversion elements, and organic transistors and the like.

Among organic electronic elements, organic EL elements are attracting attention for potential use in large-surface area solid state lighting source applications to replace incandescent lamps or gas-filled lamps or the like. Further, organic EL elements are also attracting attention as the leading self-luminous display for replacing liquid crystal displays (LCD) in the field of flat panel displays (FPD), and commercial products are becoming increasingly available.

Depending on the organic materials used, organic EL elements are broadly classified into low-molecular weight type organic EL elements and polymer type organic EL elements. In polymer type organic EL elements, polymer materials are used as the organic materials, whereas in low molecular weight type organic EL elements, low-molecular weight materials are used. Compared with low-molecular weight type organic EL elements in which film formation is mainly performed in vacuum systems, polymer type organic EL elements enable simple film formation to be performed by wet processes such as printing or inkjet application, and are therefore expected to be essential elements in future large-screen organic EL displays.

Accordingly, the development of materials that are suited to wet processes is being pursued.

### PRIOR ART DOCUMENTS

### PATENT DOCUMENT

Patent Document 1: JP 2006-279007 A
Patent Document 2: WO 2010/140553

### DISCLOSURE OF INVENTION

### PROBLEMS INVENTION AIMS TO SOLVE

Organic EL elements produced by wet processes using polymer materials have the advantages that cost reductions and surface area increases can be achieved with relative ease. However, organic EL elements containing thin films produced using conventional polymer materials still require further improvements in certain properties of the organic EL element, including the drive voltage, the emission efficiency and the emission lifespan. Moreover, because the production of organic EL elements requires high-temperature baking, the various materials used also require resistance to high-temperature processes.

Due to these requirements, various polymer materials are being investigated. However, the polymer materials disclosed in the Patent Documents listed above still have room for improvement in terms of maintenance of the hole injection properties during high-temperature processes.

In light of the above circumstances, embodiments of the present invention have the objects of providing a charge transport material containing a polymer compound, which is suitable for use in wet processes, has good resistance to high-temperature processes (maintenance of hole injection properties during high-temperature processes) and can be used in an organic electronic element, and an ink composition that contains the material. Further, other embodiments have the objects of using the above charge transport material or ink composition to provide an organic electronic element and an organic EL element having excellent lifespan characteristics, as well as a display element, an illumination device and a display device that use the organic EL element.

### MEANS FOR SOLUTION OF THE PROBLEMS

One embodiment relates to a charge transport material containing a charge transport compound for which the thermal weight reduction upon heating at 300°C is not more than 5% by mass.

Another embodiment relates to an ink composition containing the charge transport material of the embodiment described above and a solvent.

Another embodiment relates to an organic layer formed using the charge transport material of the embodiment described above, or the ink composition of the embodiment described above.

Another embodiment relates to an organic electronic element having the organic layer of the embodiment described above.

Another embodiment relates to an organic electroluminescent element having the organic layer of the embodiment described above.

Another embodiment relates to a display element provided with the organic electroluminescent element of the embodiment described above.

Another embodiment relates to an illumination device provided with the organic electroluminescent element of the embodiment described above.

Yet another embodiment relates to a display device provided with the illumination device of the embodiment described above, and a liquid crystal element as a display means.

### EFFECTS OF THE INVENTION

Embodiments of the present invention are able to provide an organic electronic element and an organic EL element having excellent durability at high temperature and excellent lifespan characteristics, and also provide a display element, an illumination device and a display device that use the organic EL element.

### BRIEF DESCRIPTION OF THE DRAWINGS

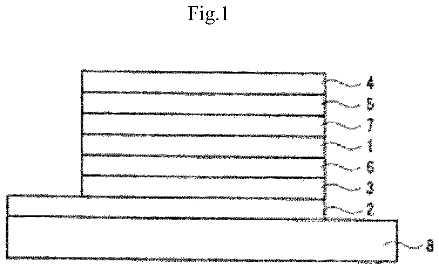

FIG. 1 is a schematic cross-sectional view illustrating one example of an organic EL element that represents one embodiment of the present invention.

### EMBODIMENTS FOR CARRYING OUT THE INVENTION

Embodiments of the present invention are described below, but the present invention is not limited to these embodiments. In this description, "mass" and "weight" are used with the same meaning.

### <Charge Transport Material>

The charge transport material of one embodiment (in this description also referred to as an "organic electronic material") contains a charge transport compound for which the thermal weight reduction upon heating at 300°C, relative to the mass prior to heating, is not more than 5% by mass. This charge transport material may contain a plurality of charge transport compounds, and in such cases, the mixture that represents the overall combination of charge transport compounds should satisfy the above thermal weight reduction requirement.

By ensuring that the thermal weight reduction of the charge transport compound is not more than 5% by mass relative to the mass prior to heating, the charge transport material can be imparted with resistance to high-temperature processes (maintenance of hole injection properties during high-temperature processes), and the heat resistance can be improved. Provided the heat resistance of the charge transport material is high, an organic layer produced using the charge transport material undergoes no deterioration in performance during high-temperature baking (for example, a temperature exceeding 200°C but less than 300°C), for example during production of an organic EL element, meaning high carrier mobility can be maintained. As a result, it is thought that the drive voltage can be reduced, or an improvement in the emission efficiency and a lengthening of the lifespan can be achieved.

This thermal weight reduction is more preferably not more than 4.5% by mass, even more preferably not more than 4.3% by mass, and still more preferably 4.1% by mass or less.

The thermal weight reduction ratio of the charge transport compound upon heating at 300°C refers to the thermal weight reduction (% by mass) when the measurement target compound is heated in the air to 300°C under temperature increase conditions of 5°C/minute. Specifically, the thermal weight reduction is measured using 10 mg of the measurement compound, using a thermogravimetric-differential thermal analysis (TG-DTA) apparatus.

Charge transport compounds can be broadly classified into low-molecular weight compounds composed of a single structural unit, and polymer compounds composed of a plurality of structural units, and either of these may be used.

Cases where the charge transport compound is a low-molecular weight compound are preferred in terms of enabling a high-purity material to be easily obtained. Cases where the charge transport compound is a polymer compound are preferred in terms of enabling easier preparation of compositions, and exhibiting superior film formability. Moreover, from the viewpoints of obtaining the advantages of both, a mixture of a low-molecular weight compound and a polymer compound may also be used as the charge transport compound.

The charge transport compound may be a polymer compound containing a plurality of the same structural unit, namely a charge transport polymer. A charge transport polymer is a polymer that has the ability to transport an electric charge, and the term "polymer" is deemed to include compounds in which the number of repeating structural units is small, so-called "oligomers". Polymer compounds composed of a plurality of structural units having charge transport properties are initially described below in further detail as examples of the charge transport compound.

### [Charge Transport Polymers]

In one embodiment, the charge transport compound is a charge transport polymer, and as described above, the polymer exhibits a small thermal weight reduction.

In order to control the thermal weight reduction of the polymer, for example, the amount of aromatic structures such as aromatic rings (aryl groups or heteroaryl groups) contained within the polymer molecule can be increased, thereby reducing the thermal weight reduction.

On the other hand, if the polymer has structures within the molecule that are easily cleaved by heating, such as ether linkages or ester linkages, then the thermal weight reduction tends to increase, and therefore the amounts of these structures are preferably adjusted.

The charge transport polymer may be linear, or may have a branched structure. The charge transport polymer preferably contains at least a divalent structural unit L having charge transport properties and a monovalent structural unit T that forms the terminal portions, and may also contain a trivalent or higher structural unit B that forms a branched portion. The charge transport polymer may have only one type of each of these structural units, or may contain a plurality of types of each structural unit. In the charge transport polymer, the various structural units are bonded together at "monovalent" to "trivalent or higher" bonding sites.

### (Structure)

Examples of partial structures contained in the charge transport polymer are described below. However, the charge transport polymer is not limited to polymers having the following partial structures. In the partial structures, "L" represents a structural unit L, "T" represents a structural unit T, and "B" represents a structural unit B. The symbol "*" represents a bonding site for bonding to another structural unit. In the following partial structures, the plurality of L units may be units having the same structure or units having mutually different structures. This also applies for the T and B units.

### Linear Charge Transport Polymer

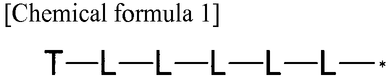

Charge Transport Polymers having Branched Structures

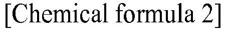

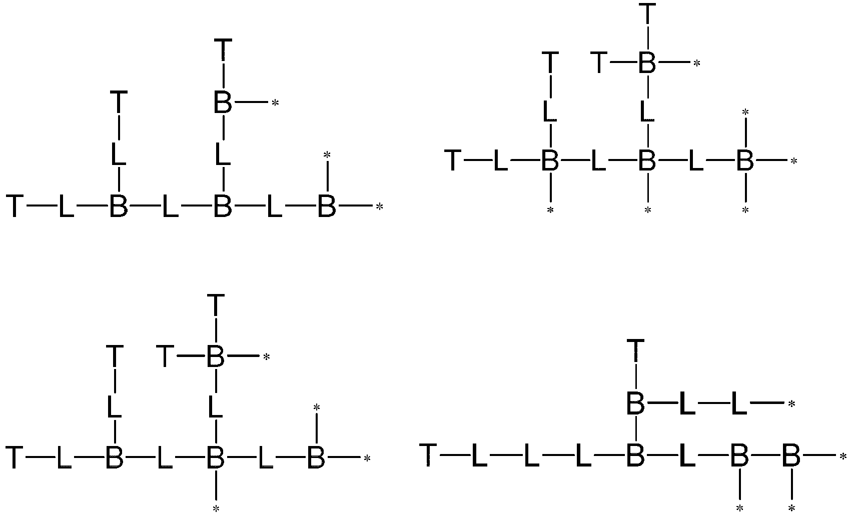

In one embodiment, the charge transport polymer is preferably a polymer having a divalent structural unit with charge transport properties. Further, in one embodiment, the charge transport polymer is preferably a polymer having a structure that branches in three or more directions, namely a polymer having a structural unit B described above.

The charge transport polymer preferably contains one or more structures selected from the group consisting of aromatic amine structures, carbazole structures, thiophene structures, bithiophene structures, benzene structures and fluorene structures, and these structures are preferably included in a structural unit L described below, but may be included in a structural unit B, or may be included in both a structural unit L and a structural unit B. By including one of these structures, the charge transport properties, and particularly the hole transport properties, can be improved.

Alternatively, from the viewpoint of improving the charge transport properties, and particularly the hole transport properties, in one embodiment, the charge transport polymer preferably contains an N-arylphenoxazine structure. This N-arylphenoxazine structure is preferably included in a structural unit B, but may be included in a structural unit L, or may be included in both a structural unit B and a structural unit L. The aryl group of the N-arylphenoxazine structure is preferably a phenyl group or a naphthyl group or the like. These aryl groups may be substituted with a linear, cyclic or branched alkyl group of 1 to 22 carbon atoms.

### (Structural Unit L)

The structural unit L is a divalent structural unit having charge transport properties. There are no particular limitations on the structural unit L, provided it includes an atom grouping having the ability to transport an electric charge. For example, the structural unit L may be selected from among substituted or unsubstituted structures including aromatic amine structures, carbazole structures, thiophene structures, bithiophene structures, fluorene structures, benzene structures, biphenylene structures, terphenylene structures, naphthalene structures, anthracene structures, tetracene structures, phenanthrene structures, dihydrophenanthrene structures, pyridine structures, pyrazine structures, quinoline structures, isoquinoline structures, quinoxaline structures, acridine structures, diazaphenanthrene structures, furan structures, pyrrole structures, oxazole structures, oxadiazole structures, thiazole structures, thiadiazole structures, triazole structures, benzothiophene structures, benzoxazole structures, benzoxadiazole structures, benzothiazole structures, benzothiadiazole structures, benzotriazole structures, N-arylphenoxazine structures, and structures containing one, or two or more, of the above structures. The aromatic amine structures are preferably triarylamine structures, and more preferably triphenylamine structures.

In one embodiment, from the viewpoint of obtaining superior hole transport properties, the structural unit L is preferably selected from among substituted or unsubstituted structures including aromatic amine structures, carbazole structures, thiophene structures, bithiophene structures, fluorene structures, benzene structures, pyrrole structures, and structures containing one, or two or more, of these structures, and is more preferably selected from among substituted or unsubstituted structures including aromatic amine structures, carbazole structures, and structures containing one, or two or more, of these structures. In another embodiment, from the viewpoint of obtaining superior electron transport properties, the structural unit L is preferably selected from among substituted or unsubstituted structures including fluorene structures, benzene structures, phenanthrene structures, pyridine structures, quinoline structures, and structures containing one, or two or more, of these structures.

Specific examples of the structural unit L are shown below. However, the structural unit L is not limited to the following structures.

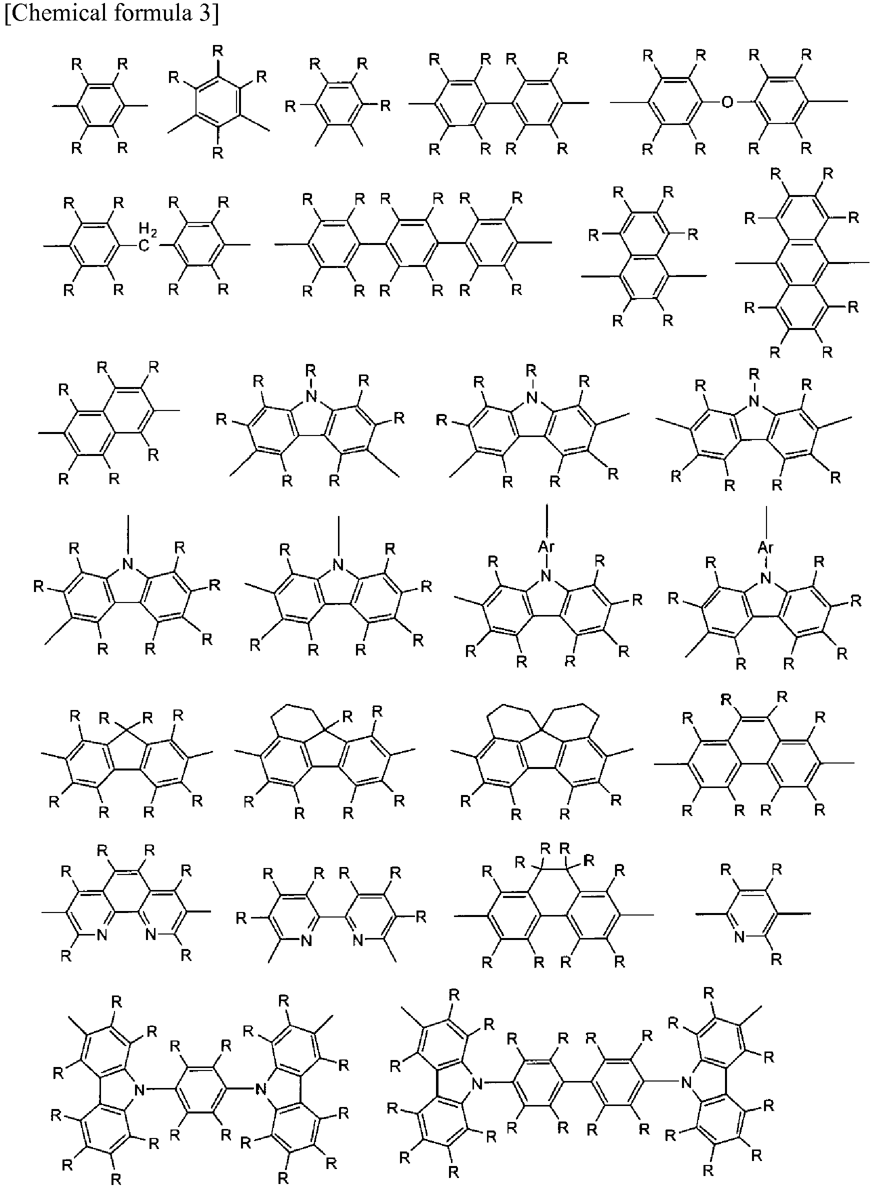

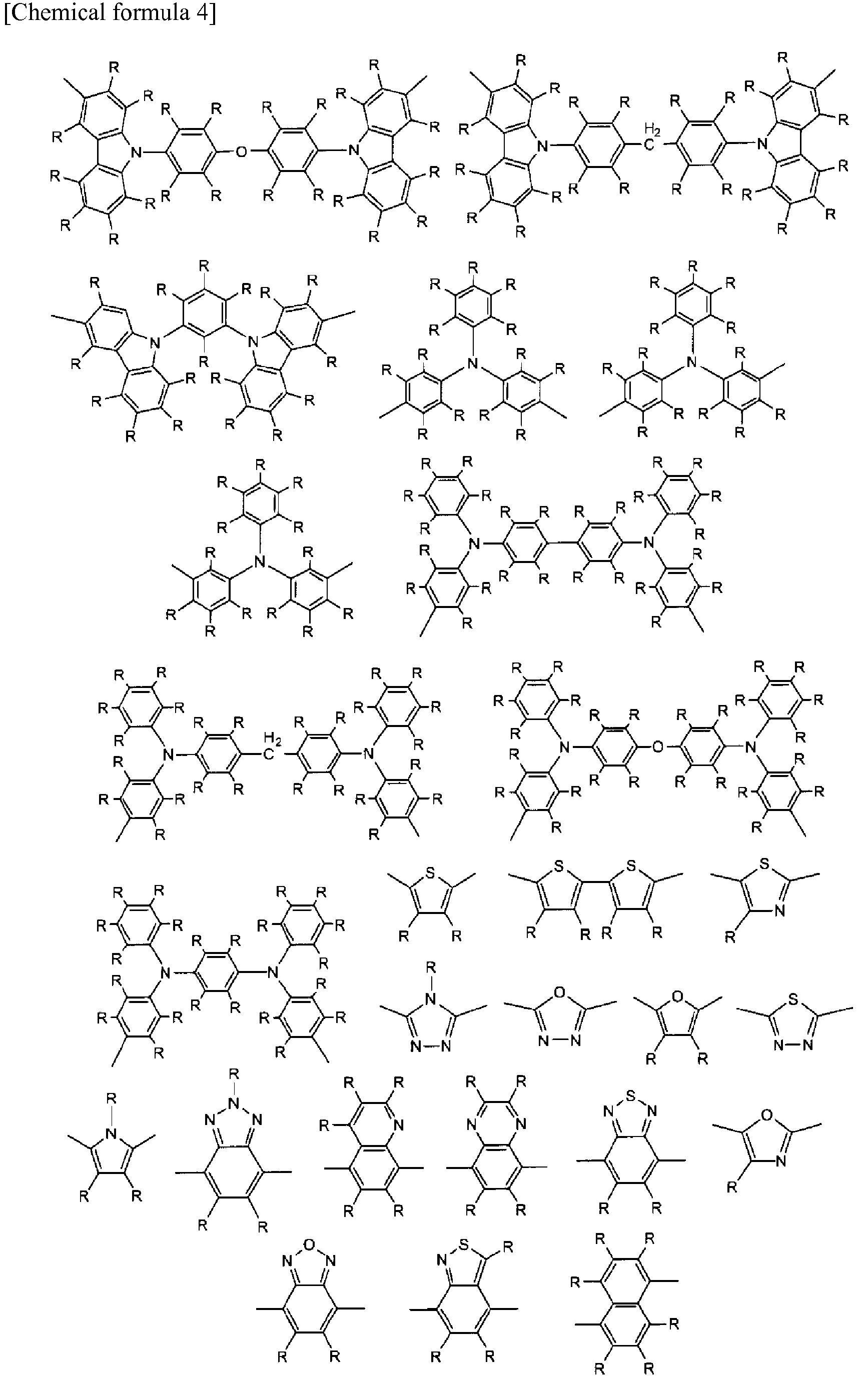

Each R independently represents a hydrogen atom or a substituent. It is preferable that each R is independently selected from a group consisting of -R¹, -OR², - SR³, -OCOR⁴, -COOR⁵, -SiR⁶R⁷R⁸, halogen atoms, and groups containing a polymerizable functional group described below. Each of R¹ to R⁸ independently represents a hydrogen atom; a linear, cyclic or branched alkyl group of 1 to 22 carbon atoms; or an aryl group or heteroaryl group of 2 to 30 carbon atoms. An aryl group is an atom grouping in which one hydrogen atom has been removed from an aromatic hydrocarbon. A heteroaryl group is an atom grouping in which one hydrogen atom has been removed from an aromatic heterocycle. The alkyl group may be further substituted with an aryl group or heteroaryl group of 2 to 20 carbon atoms, and the aryl group or heteroaryl group may be further substituted with a linear, cyclic or branched alkyl group of 1 to 22 carbon atoms. R is preferably a hydrogen atom, an alkyl group, an aryl group, or an alkyl-substituted aryl group. Ar represents an arylene group or heteroarylene group of 2 to 30 carbon atoms. An arylene group is an atom grouping in which two hydrogen atoms have been removed from an aromatic hydrocarbon. A heteroarylene group is an atom grouping in which two hydrogen atoms have been removed from an aromatic heterocycle. Ar is preferably an arylene group, and is more preferably a phenylene group.

Examples of the aromatic hydrocarbon include monocyclic hydrocarbons, condensed ring hydrocarbons, and polycyclic hydrocarbons in which two or more selected from among monocyclic hydrocarbons and condensed ring hydrocarbons are bonded together via a single bond. Examples of the aromatic heterocycles include monocyclic heterocycles, condensed ring heterocycles, and polycyclic heterocycles in which two or more heterocycles selected from among monocyclic heterocycles and condensed ring heterocycles are bonded together via a single bond.

### (Structural Unit T)

The structural unit T is a monovalent structural unit that constitutes a terminal portion of the charge transport polymer. There are no particular limitations on the structural unit T, which may be selected from among substituted or unsubstituted structures including aromatic hydrocarbon structures, aromatic heterocyclic structures, and structures containing one, or two or more, of these structures. The structural unit T may have a same structure to the structural unit L. In one embodiment, from the viewpoint of imparting durability to the polymer without impairing the charge transport properties, the structural unit T is preferably a substituted or unsubstituted aromatic hydrocarbon structure, and is more preferably a substituted or unsubstituted benzene structure. Further, in another embodiment, when the charge transport polymer has a polymerizable functional group at a terminal portion in the manner described below, the structural unit T may be a polymerizable structure (for example, a polymerizable functional group such as a pyrrolyl group).

A specific example of the structural unit T is shown below. However, the structural unit T is not limited to the structure below.

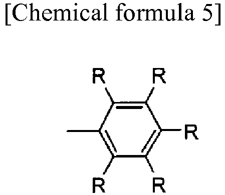

R is the same as R described in relation to the structural unit L. In those cases where the charge transport polymer has a polymerizable functional group at a terminal portion, it is preferable that at least one R is a group containing a polymerizable functional group.

In one embodiment, in order to reduce the thermal weight reduction for the charge transport polymer, it is preferable that a polycyclic structure based on a polycyclic aromatic hydrocarbon or aromatic amine or the like is introduced as a structural unit T. Examples of the polycyclic aromatic hydrocarbon structures include atom groupings in which one hydrogen atom has been removed from naphthalene, anthracene, phenanthrene, pyrene, or benzopyrene or the like. In terms of the aromatic amine structures, triarylamine structures are preferred, and more specific examples include atom groupings in which one hydrogen atom has been removed from triphenylamine, a phenylnaphthylamine (such as N-phenyl-1-naphthylamine), a diphenylnaphthylamine (such as N,N-diphenyl-1-naphthylamine), a phenyldinaphthylamine (such as N-phenyl-2,2'-naphthylamine), or trinaphthylamine or the like. Two or more of these structures may also be combined.

In those cases where these types of polycyclic structures are introduced as a structural unit T, the amount of polycyclic structures, relative to the total of all the structural units T, is preferably at least 50 mol%, is more preferably at least 60 mol%, and is further preferably at least 70 mol%. Alternatively, relative to the total of all the structural units L, T and B, the amount of these polycyclic structures is preferably from 15 to 50 mol%.

### (Structural Unit B)

The structural unit B is a trivalent or higher structural unit that constitutes a branched portion in those cases where the charge transport polymer has a branched structure. From the viewpoint of improving the durability of the organic electronic element, the structural unit B is preferably not higher than hexavalent, and is more preferably either trivalent or tetravalent. The structural unit B is preferably a unit that has charge transport properties. For example, from the viewpoint of improving the durability of the organic electronic element, the structural unit B is preferably selected from among substituted or unsubstituted structures including aromatic amine structures, carbazole structures, condensed polycyclic aromatic hydrocarbon structures, and structures containing one, or two or more, of these structures.

Specific examples of the structural unit B are shown below. However, the structural unit B is not limited to the following structures.

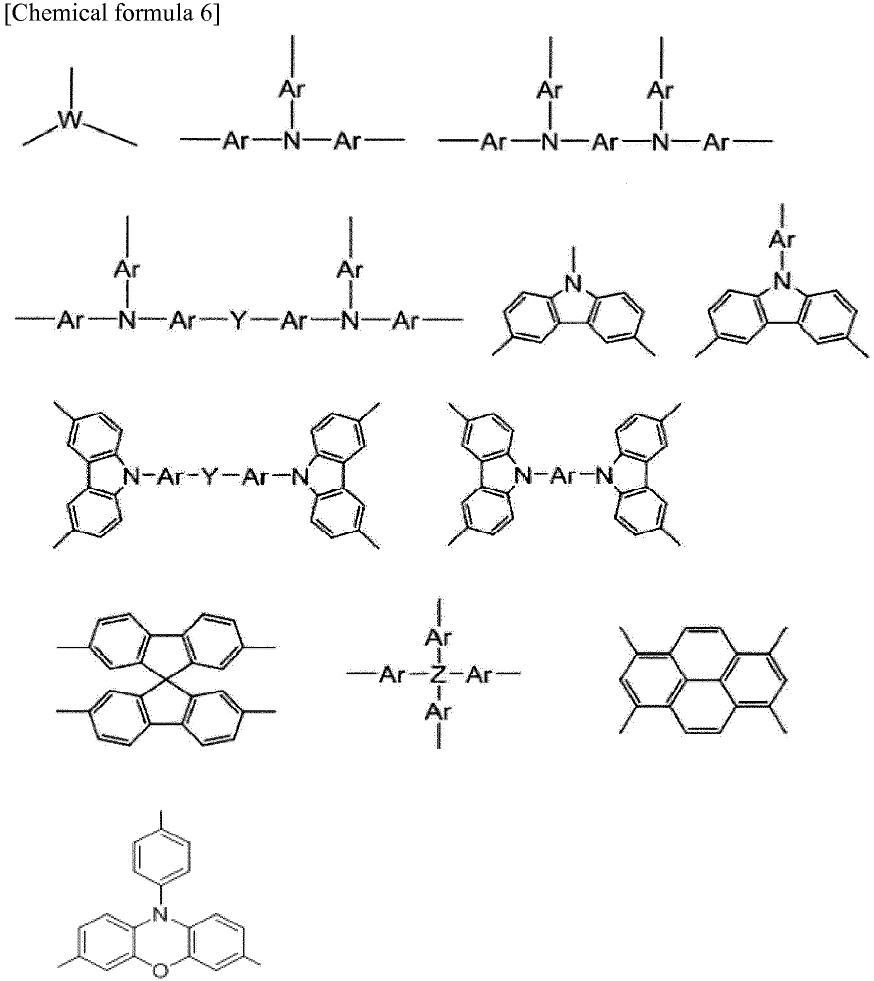

W represents a trivalent linking group, and for example, represents an arenetriyl group or heteroarenetriyl group of 2 to 30 carbon atoms. An arenetriyl group is an atom grouping in which three hydrogen atoms have been removed from an aromatic hydrocarbon. A heteroarenetriyl is an atom grouping in which three hydrogen atoms have been removed from an aromatic heterocycle. Each Ar independently represents a divalent linking group, and for example, may represent an arylene group or heteroarylene group of 2 to 30 carbon atoms. Ar preferably represents an arylene group, and more preferably a phenylene group. Y represents a divalent linking group, and examples include divalent groups in which an additional hydrogen atom has been removed from any of the R groups having one or more hydrogen atoms (but excluding groups containing a polymerizable functional group) described in relation to the structural unit L. Z represents a carbon atom, a silicon atom or a phosphorus atom. In the structural units, the benzene rings and Ar groups may have a substituent, and examples of the substituent include the R groups in the structural unit L.

In one embodiment, in order to reduce the thermal weight reduction for the charge transport polymer, it is preferable that a heteroarylene structure is included as a structural unit B, and of the possible structures, an aromatic amine structure, a carbazole structure, or an N-arylphenoxazine structure or the like is preferred. The amount of these heteroarylene structures that function as structural units B, relative to the total of all the structural units B, is preferably at least 50 mol%, and in order of increasing preference, is more preferably at least 60 mol%, at least 70 mol%, or 80 mol% or greater.

When the charge transport polymer is a hole transport compound, from the viewpoints of obtaining superior hole injection properties and hole transport properties, the hole transport compound preferably has at least one of a structural unit having an aromatic amine structure and a structural unit having a carbazole structure as a main structural unit. From these viewpoints, the proportion of all those structural units having at least one of an aromatic amine structure and a carbazole structure, relative to the total number of all the structural units (excluding terminal structural units) in the charge transport polymer, is preferably at least 40%, more preferably at least 45%, and even more preferably 50% or greater. This proportion of those structural units having at least one of an aromatic amine structure and a carbazole structure may represent 100% of the total number of all the structural units.

### (Polymerizable Functional Group)

In one embodiment, from the viewpoint of enabling the polymer to be cured by a polymerization reaction, thereby changing the solubility in solvents, the charge transport polymer preferably has at least one polymerizable functional group. A "polymerizable functional group" refers to a group which is able to form bonds upon the application of heat and/or light.

For example, in those cases where a polymerization initiator is included in a hole injection layer, and a charge transport polymer having a polymerizable functional group is used in a hole transport layer, the hole transport layer can be cured, and as a result, a light-emitting layer formed from an ink or the like can be applied to the top of the hole transport layer without dissolving the hole transport layer. Light-emitting layers are generally applied using an aromatic hydrocarbon-based solvent, and therefore it is preferable that the introduction of the polymerizable functional group yields a charge transport polymer that is unlikely to dissolve even upon immersion in toluene.

Examples of the polymerizable functional group include groups having a carbon-carbon multiple bond (such as a vinyl group, allyl group, butenyl group, ethynyl group, acryloyl group, acryloyloxy group, acryloylamino group, methacryloyl group, methacryloyloxy group, methacryloylamino group, vinyloxy group and vinylamino group), groups having a small ring (including cyclic alkyl groups such as a cyclopropyl group and cyclobutyl group; cyclic ether groups such as an epoxy group (oxiranyl group) and oxetane group (oxetanyl group); diketene groups; episulfide groups; lactone groups; and lactam groups); and heterocyclic groups (such as a furanyl group, pyrrolyl group, thiophenyl group and siloyl group). Particularly preferred polymerizable functional groups include substituted or unsubstituted vinyl groups, acryloyl groups, methacryloyl groups, epoxy groups and oxetane groups, and from the viewpoints of improving the reactivity and the characteristics of the organic electronic element, a substituted or unsubstituted vinyl group, oxetane group or epoxy group is even more preferred. These polymerizable functional groups may have a substituent. The substituent is preferably a linear, cyclic or branched saturated alkyl group of 1 to 22 carbon atoms. This number of carbon atoms is more preferably from 1 to 8, and even more preferably from 1 to 4. The substituent is most preferably a linear saturated alkyl group of 1 to 4.

From the viewpoints of increasing the degree of freedom associated with the polymerizable functional group and facilitating the polymerization reaction, the main backbone of the charge transport polymer and the polymerizable functional group are preferably linked via an alkylene chain. Further, in the case where, for example, the organic layer is to be formed on an electrode, from the viewpoint of enhancing the affinity with hydrophilic electrodes of ITO or the like, the main backbone and the polymerizable functional group are preferably linked via a hydrophilic chain such as an ethylene glycol chain or a diethylene glycol chain. Moreover, from the viewpoint of making it easier to prepare the monomer used for introducing the polymerizable functional group, the charge transport polymer may have an ether linkage or an ester linkage at the terminal of the alkylene chain and/or the hydrophilic chain, namely, at the linkage site between these chains and the polymerizable functional group, and/or at the linkage site between these chains and the charge transport polymer backbone. The aforementioned "group containing a polymerizable functional group" means a polymerizable functional group itself, or a group composed of a combination of a polymerizable functional group and an alkylene chain or the like. Examples of groups that can be used favorably as this group containing a polymerizable functional group include the groups exemplified in WO 2010/140553.

The polymerizable functional group may be introduced at a terminal portion of the charge transport polymer (namely, a structural unit T), at a portion other than a terminal portion (namely, a structural unit L or B), or at both a terminal portion and a portion other than a terminal. From the viewpoint of the curability, the polymerizable functional group is preferably introduced at least at a terminal portion, and from the viewpoint of achieving a combination of favorable curability and charge transport properties, is preferably introduced only at terminal portions. Further, in those cases where the charge transport polymer has a branched structure, the polymerizable functional group may be introduced within the main chain of the charge transport polymer, within a side chain, or within both the main chain and a side chain.

From the viewpoint of contributing to a change in the solubility, the polymerizable functional group is preferably included in the charge transport polymer in a large amount. On the other hand, from the viewpoint of not impeding the charge transport properties, the amount included in the charge transport polymer is preferably kept small. The amount of the polymerizable functional group may be set as appropriate with due consideration of these factors.

For example, from the viewpoint of obtaining a satisfactory change in the solubility, the number of polymerizable functional groups per one molecule of the charge transport polymer is preferably at least 2, and more preferably 3 or greater. Further, from the viewpoint of maintaining good charge transport properties, the number of polymerizable functional groups is preferably not more than 1,000, and more preferably 500 or fewer.

The number of polymerizable functional groups per one molecule of the charge transport polymer can be determined as an average value from the amount of the polymerizable functional group used in synthesizing the charge transport polymer (for example, the amount added of the monomer having the polymerizable functional group), the amounts added of the monomers corresponding with the various structural units, and the mass average molecular weight of the charge transport polymer and the like. Further, the number of polymerizable functional groups can also be calculated as an average value using the ratio between the integral of the signal attributable to the polymerizable functional group and the integral of the total spectrum in the ¹H-NMR (nuclear magnetic resonance) spectrum of the charge transport polymer, and the mass average molecular weight of the charge transport polymer and the like. In terms of simplicity, if the amounts added of the monomers are clear, then the number of polymerizable functional groups is preferably determined from these amounts added of the monomers.

### (Number Average Molecular Weight)

The number average molecular weight of the charge transport polymer can be adjusted appropriately with due consideration of the solubility in solvents and the film formability and the like. From the viewpoint of ensuring superior charge transport properties, the number average molecular weight is preferably at least 500, more preferably at least 1,000, even more preferably at least 2,000, and still more preferably 5,000 or greater. Further, from the viewpoints of maintaining favorable solubility in solvents and facilitating the preparation of ink compositions, the number average molecular weight is preferably not more than 1,000,000, more preferably not more than 100,000, even more preferably not more than 50,000, and still more preferably 30,000 or less.

### (Mass Average Molecular Weight)

The mass average molecular weight of the charge transport polymer can be adjusted appropriately with due consideration of the solubility in solvents and the film formability and the like. From the viewpoint of ensuring superior charge transport properties, the mass average molecular weight is preferably at least 1,000, more preferably at least 5,000, even more preferably at least 10,000, and still more preferably 30,000 or greater. Further, from the viewpoints of maintaining favorable solubility in solvents and facilitating the preparation of ink compositions, the mass average molecular weight is preferably not more than 1,000,000, more preferably not more than 700,000, even more preferably not more than 400,000, and in order of increasing preference, still more preferably not more than 200,000, or 100,000 or less.

The number average molecular weight and the mass average molecular weight can be measured by gel permeation chromatography (GPC), using a calibration curve of standard polystyrenes. Specifically, measurements may be performed under the following conditions.
Feed pump: L-6050, manufactured by Hitachi High-Technologies Corporation
UV-Vis detector: L-3000, manufactured by Hitachi High-Technologies Corporation
Columns: Gelpack (a registered trademark) GL-A160S / GL-A150S, manufactured by Hitachi Chemical Co., Ltd.
Eluent: THF (for HPLC, stabilizer-free), manufactured by Wako Pure Chemical Industries, Ltd.
Flow rate: 1 mL/min
Column temperature: room temperature
Molecular weight standards: standard polystyrenes

### (Proportions of Structural Units)

From the viewpoint of ensuring satisfactory charge transport properties, the proportion of the structural unit L contained in the charge transport polymer, relative to the total of all the structural units, is preferably at least 10 mol%, more preferably at least 20 mol%, and even more preferably 30 mol% or higher. If the structural unit T and the optionally included structural unit B are taken into consideration, then the proportion of the structural unit L is preferably not more than 95 mol%, more preferably not more than 90 mol%, and even more preferably 85 mol% or less.

From the viewpoint of improving the characteristics of the organic electronic element, or from the viewpoint of suppressing an increase in viscosity and enabling more favorable synthesis of the charge transport polymer, the proportion of the structural unit T contained in the charge transport polymer, relative to the total of all the structural units, is preferably at least 5 mol%, more preferably at least 10 mol%, and even more preferably 15 mol% or higher. Further, from the viewpoint of ensuring satisfactory charge transport properties, the proportion of the structural unit T is preferably not more than 60 mol%, more preferably not more than 55 mol%, and even more preferably 50 mol% or less.

In those cases where the charge transport polymer includes a structural unit B, from the viewpoint of improving the durability of the organic electronic element, the proportion of the structural unit B, relative to the total of all the structural units, is preferably at least 1 mol%, more preferably at least 5 mol%, and even more preferably 10 mol% or higher. Further, from the viewpoints of suppressing an increase in viscosity and enabling more favorable synthesis of the charge transport polymer, or from the viewpoint of ensuring satisfactory charge transport properties, the proportion of the structural unit B is preferably not more than 50 mol%, more preferably not more than 40 mol%, and even more preferably 30 mol% or less.

In those cases where the charge transport polymer has a polymerizable functional group, from the viewpoint of ensuring efficient curing of the charge transport polymer, the proportion of the polymerizable functional group, relative to the total of all the structural units, is preferably at least 0.1 mol%, more preferably at least 1 mol%, and even more preferably 3 mol% or higher. Further, from the viewpoint of ensuring favorable charge transport properties, the proportion of the polymerizable functional group is preferably not more than 70 mol%, more preferably not more than 60 mol%, and even more preferably 50 mol% or less. Here, the "proportion of the polymerizable functional group" refers to the proportion of structural units having the polymerizable functional group.

Considering the balance between the charge transport properties, the durability, and the productivity and the like, the ratio (molar ratio) between the structural unit L and the structural unit T is preferably L:T = 100:(1 to 70), more preferably 100:(3 to 50), and even more preferably 100:(5 to 30). Further, in those cases where the charge transport polymer also includes the structural unit B, the ratio (molar ratio) between the structural unit L, the structural unit T and the structural unit B is preferably L:T:B = 100:(10 to 200):(10 to 100), more preferably 100:(20 to 180):(20 to 90), and even more preferably 100:(40 to 160):(30 to 80).

The proportion of each structural unit can be determined from the amounts added of the monomers corresponding with that structural unit during synthesis of the charge transport polymer. Further, the proportion of each structural unit can also be calculated as an average value using the integral of the spectrum attributable to the structural unit in the ¹H-NMR spectrum of the charge transport polymer. In terms of simplicity, if the amounts added of the monomers are clear, then the proportion of the structural unit preferably employs the value determined using the amounts added of the monomers.

### (Production Method)

The charge transport polymer can be produced by various synthesis methods, and there are no particular limitations. For example, known coupling reactions such as the Suzuki coupling, Negishi coupling, Sonogashira coupling, Stille coupling and Buchwald-Hartwig coupling reactions can be used. The Suzuki coupling is a reaction in which a cross-coupling reaction is initiated between an aromatic boronic acid derivative and an aromatic halide using a Pd catalyst. By using a Suzuki coupling, the charge transport polymer can be produced easily by bonding together the desired aromatic rings.

In the coupling reaction, a Pd(0) compound, Pd(II) compound, or Ni compound or the like is used as a catalyst. Further, a catalyst species generated by mixing a precursor such as tris(dibenzylideneacetone)dipalladium(0) or palladium(II) acetate with a phosphine ligand can also be used. Reference may also be made to WO 2010/140553 in relation to synthesis methods for the charge transport polymer.

### [Dopant]

The charge transport material may also contain a dopant. There are no particular limitations on the dopant, provided it is a compound that yields a doping effect upon addition to the charge transport material, enabling an improvement in the charge transport properties. Doping includes both p-type doping and n-type doping. In p-type doping, a substance that functions as an electron acceptor is used as the dopant, whereas in n-type doping, a substance that functions as an electron donor is used as the dopant. To improve the hole transport properties, p-type doping is preferably used, whereas to improve the electron transport properties, n-type doping is preferably used. The dopant used in the charge transport material may be a dopant that exhibits either a p-type doping effect or an n-type doping effect. Further, a single type of dopant may be added alone, or a mixture of a plurality of dopant types may be added.

The dopants used in p-type doping are electron-accepting compounds, and examples include Lewis acids, protonic acids, transition metal compounds, ionic compounds, halogen compounds and π-conjugated compounds. Specific examples include Lewis acids such as FeCl₃, PF₅, AsF₅, SbF₅, BF₅, BCl₃ and BBr₃; protonic acids, including inorganic acids such as HF, HC1, HBr, HNO₅, H₂SO₄ and HClO₄, and organic acids such as benzenesulfonic acid, p-toluenesulfonic acid, dodecylbenzenesulfonic acid, polyvinylsulfonic acid, methanesulfonic acid, trifluoromethanesulfonic acid, trifluoroacetic acid, 1-butanesulfonic acid, vinylphenylsulfonic acid and camphorsulfonic acid; transition metal compounds such as FeOCl, TiCl₄, ZrCl₄, HfCl₄, NbF₅, AlCl₃, NbCl₅, TaCl₅ and MoF₅; ionic compounds, including salts containing a perfluoro anion such as a tetrakis(pentafluorophenyl)borate ion, tris(trifluoromethanesulfonyl)methide ion, bis(trifluoromethanesulfonyl)imide ion, hexafluoroantimonate ion, AsF₆⁻ (hexafluoroarsenate ion), BF₄⁻ (tetrafluoroborate ion) or PF₆⁻ (hexafluorophosphate ion), and salts having a conjugate base of an aforementioned protonic acid as an anion; halogen compounds such as Cl₂, Br₂, I₂, ICl, ICl₃, IBr and IF; and π-conjugated compounds such as TCNE (tetracyanoethylene) and TCNQ (tetracyanoquinodimethane). Further, the electron-accepting compounds disclosed in JP 2000-36390 A, JP 2005-75948 A, and JP 2003-213002 A and the like can also be used. Lewis acids, ionic compounds, and π-conjugated compounds and the like are preferred.

The dopants used in n-type doping are electron-donating compounds, and examples include alkali metals such as Li and Cs; alkaline earth metals such as Mg and Ca; salts of alkali metals and/or alkaline earth metals such as LiF and Cs₂CO₃; metal complexes; and electron-donating organic compounds.

In those cases where the charge transport polymer has a polymerizable functional group, in order to make it easier to change the solubility of the organic layer, the use of a compound that can function as a polymerization initiator for the polymerizable functional group as the dopant is preferred.

### [Other Optional Components]

The charge transport material (organic electronic material) may also contain charge transport low-molecular weight compounds, or other polymers or the like.

### [Contents]

From the viewpoint of obtaining favorable charge transport properties, the amount of the charge transport polymer, relative to the total mass of the charge transport material, is preferably at least 50% by mass, more preferably at least 70% by mass, and even more preferably 80% by mass or greater. The amount may be 100% by mass.

When a dopant is included, from the viewpoint of improving the charge transport properties of the charge transport material, the amount of the dopant relative to the total mass of the charge transport material is preferably at least 0.01% by mass, more preferably at least 0.1% by mass, and even more preferably 0.5% by mass or greater. Further, from the viewpoint of maintaining favorable film formability, the amount of the dopant relative to the total mass of the charge transport material is preferably not more than 50% by mass, more preferably not more than 30% by mass, and even more preferably 20% by mass or less.

### [Charge Transport Compound (1)]

In one embodiment, the charge transport material (organic electronic material) contains at least one charge transport compound (hereafter also referred to as the "charge transport compound (1)") having a specific structural region represented by formula (I) shown below.

-Ar-X-Y-Z (I)

In the formula, Ar represents an arylene group or heteroarylene group of 2 to 30 carbon atoms, X represents a linking group, Y represents an aliphatic hydrocarbon group of 1 to 10 carbon atoms, and Z represents a substituted or unsubstituted polymerizable functional group.

In the above charge transport material, the polymerizable functional group preferably contains at least one group selected from the group consisting of an oxetane group, epoxy group, vinyl group, acryloyl group and methacryloyl group.

In the above charge transport material, the structural region represented by formula (I) is preferably positioned at the terminal of the charge transport compound (1).

In the above charge transport material, the thermal weight reduction of the charge transport compound (1) upon heating at 300°C is preferably not more than 5% by mass.

In the above charge transport material, the charge transport compound (1) is preferably a hole injection layer material.

In the above charge transport material, the charge transport compound (1) preferably contains a divalent structural unit having charge transport properties.

In the above charge transport material, the charge transport compound (1) preferably contains at least one structure selected from the group consisting of aromatic amine structures, carbazole structures, thiophene structures, bithiophene structures, benzene structures, phenoxazine structures and fluorene structures.

In the above charge transport material, the charge transport compound (1) preferably has a structure that is branched in three or more directions.

In the above charge transport material, the charge transport compound (1) is preferably a charge transport polymer.

The charge transport material may contain two or more types of the above charge transport compound (1), and may also contain one or more other charge transport compounds.

This charge transport compound (1) is a compound which has at least one structural unit having charge transport properties, and in which at least one of the structural units described above contains a structural region represented by the above formula (I).

In formula (I), Ar represents an arylene group or heteroarylene group of 2 to 30 carbon atoms. An arylene group means a group having a structure in which two hydrogen atoms have been removed from an aromatic hydrocarbon. A heteroarylene group means a group having a structure in which two hydrogen atoms have been removed from an aromatic heterocycle. The aromatic hydrocarbon and the aromatic heterocycle may each have a single ring structure such as benzene, or may have a condensed ring structure having rings condensed together such as naphthalene.

Specific examples of the aromatic hydrocarbon include benzene, naphthalene, anthracene, tetracene, fluorene and phenanthrene. Specific examples of the aromatic heterocycle include pyridine, pyrazine, quinoline, isoquinoline, acridine, phenanthroline, furan, pyrrole, thiophene, carbazole, oxazole, oxadiazole, thiadiazole, triazole, benzoxazole, benzoxadiazole, benzothiadiazole, benzotriazole, and benzothiophene.

The aromatic hydrocarbon and the aromatic heterocycle may also have a polycyclic structure in which two or more aromatic structures selected from among monocyclic and condensed ring structures are bonded together via a single bond. Examples of aromatic hydrocarbons having this type of polycyclic structure include biphenyl, terphenyl and triphenylbenzene. The aromatic hydrocarbon and the aromatic heterocycle may each be unsubstituted, or have one or more substituents. The substituent may, for example, be a linear, cyclic or branched alkyl group of 1 to 22 carbon atoms. This number of carbon atoms is more preferably from 1 to 15, even more preferably from 1 to 12, and particularly preferably from 1 to 6.

In one embodiment, Ar is preferably a phenylene group or a naphthylene group, and is more preferably a phenylene group.

In formula (I), X represents at least one type of linking group selected from the group consisting of groups of formulas (x1) to (x10) shown below.

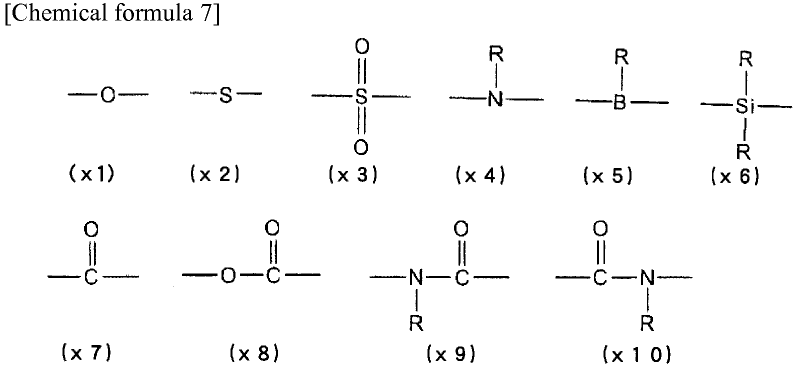

Each R independently represents a hydrogen atom, a linear, cyclic or branched alkyl group of 1 to 22 carbon atoms, or an aryl group or heteroaryl group of 2 to 30 carbon atoms. In one embodiment, R is preferably a linear, cyclic or branched alkyl group of 1 to 22 carbon atoms. The number of carbon atoms is more preferably from 2 to 16, even more preferably from 3 to 12, and particularly preferably from 4 to 8. In another embodiment, R is preferably an aryl group of 6 to 30 carbon atoms, and is more preferably a phenyl group or naphthyl group, and even more preferably a phenyl group.

In one embodiment, the above linking group X is preferably x1. In other words, the charge transport compound (1) preferably has a structural region represented by formula (I-1) below.

-Ar-O-Y-Z (I-1)

In formula (I), Y represents a divalent aliphatic hydrocarbon group of 1 to 10 carbon atoms. The aliphatic hydrocarbon group may be linear, branched or cyclic, or may have a combination of these structures. The aliphatic hydrocarbon group may be saturated or unsaturated.

In one embodiment, from the viewpoint of the ease of availability of the monomer that represents the raw material, Y is preferably an aliphatic hydrocarbon group having a linear structure, and is preferably saturated. From these viewpoints, Y in formula (I) is preferably -(CH₂)ₙ-. In other words, in one embodiment, the charge transport compound (1) preferably has a structural region represented by formula (1-2) below.

-Ar-X-(CH₂)ₙ-Z (I-2)

In the above formula, n is from 1 to 10, preferably from 1 to 8, and more preferably from 1 to 6. From the viewpoint of the heat resistance, n is even more preferably from 1 to 4, and n is most preferably either 1 or 2.

As described above, the charge transport compound (1) preferably has a structural region represented by at least one of the above formulas (I-1) and (1-2), and more preferably has a structural region represented by formula (1-3) shown below.

-Ar-O-(CH₂)ₙ-Z (I-3)

In each of the above formulas, Z represents a polymerizable functional group. The "polymerizable functional group" is as described above in the section relating to the charge transport polymer.

In one embodiment, from the viewpoint of the storage stability, the polymerizable functional group Z is preferably an oxetane group represented by formula (z1) below. In the formula, R represents a hydrogen atom or a saturated alkyl group of 1 to 4 carbon atoms. It is particularly preferable that R represents a methyl group or an ethyl group.

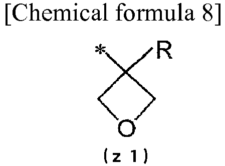

The charge transport compound (1) having at least one structural region represented by formula (I) contains at least one polymerizable functional group Z within the structure. Compounds containing the polymerizable functional group can be cured by a polymerization reaction, and as a result of the curing, the solubility in solvents can be changed. Accordingly, the charge transport compound (1) having at least one structural region represented by formula (I) is a material that exhibits excellent curability and is suited to wet processes.

The charge transport compound (1) in the present embodiment may be any compound that has a structural region represented by the above formula (I) and has the ability to transport an electric charge. In one embodiment, the transported charge is preferably a positive hole. If the compound has hole transport properties, then the compound can be used, for example, as the material for a hole injection layer or a hole transport layer in an organic EL element. Further, if the compound has electron transport properties, then the compound can be used as the material for an electron transport layer or an electron injection layer. Furthermore, if the compound is able to transport both holes and electrons, then the compound can be used as the material of a light-emitting layer or the like. In one embodiment, the charge transport compound (1) is preferably used as the material for a hole injection layer and/or hole transport layer, and is more preferably used as a hole injection layer material.

In one embodiment, from the viewpoint of the heat resistance, the charge transport compound (1) preferably has a thermal weight reduction upon heating at 300°C of not more than 5% by mass relative to the mass prior to heating. The thermal weight reduction is more preferably not more than 3.5% by mass. Moreover, in order of increasing preference, the thermal weight reduction is more preferably not more than 2.5% by mass, not more than 1.5% by mass, or not more than 1.0% by mass, and is most preferably 0.5% by mass or less.

As described above, the charge transport compound (1) has one, or two or more, structural regions having charge transport properties, and provided at least one of the structural units described above has a structural region represented by the above formula (I), in one embodiment, the charge transport compound (1) may have a structure that is branched in three or more directions. The charge transport compound (1) can be broadly classified into low-molecular weight compounds composed of a single structural unit, and polymer compounds composed of a plurality of structural units, and either type of compound may be used. In those cases where a charge transport polymer containing a structural region of the above formula (1) (hereafter also referred to as the "charge transport polymer (1)") is used as the charge transport compound (1), the thermal weight reduction for the material can be easily adjusted to a value within the above range.

The charge transport compound (1) has at least one structural region represented by formula (I) described above and shown below within the molecular structure.

-Ar-X-Y-Z (I)

Charge transport polymers containing a structural region represented by -Ar-CH₂-O- at a terminal portion readily undergo intramolecular bond cleavage upon heating, and tend to have poor heat resistance. In contrast, by forming a charge transport polymer (1) having a structural region represented by formula (I), the heat resistance of the charge transport polymer can be improved.

As the heat resistance improves, the degree of thermal degradation of the organic layer in high-temperature processes, for example during element production, is improved, making it easier to maintain the performance of the organic layer. In particular, in those cases where an organic layer is formed by a coating method using the charge transport polymer (1) according to the present embodiment, deterioration in the performance of the organic layer is suppressed, even during high-temperature baking treatments, meaning superior carrier mobility can be maintained.

In one embodiment, the charge transport polymer (1) includes a structural region represented by formula (I) in at least one of the above structural units L, B and T that constitute the polymer, and there are no particular limitations on the position at which the structural region is introduced. For example, the structural region may be introduced as a substituent in a structural unit L or B. In a preferred embodiment, from the viewpoint of improving the curability, the structural region represented by formula (I) preferably exists in a structural unit T that constitutes at least one terminal portion of the charge transport polymer. A charge transport polymer in which the structural region represented by formula (I) exists in a structural unit T that constitutes a terminal portion is also preferred from the viewpoint of the ease of synthesis of the monomer compounds used for forming the charge transport polymer.

As described above, the structural unit T is a monovalent structural unit that constitutes a terminal portion of the charge transport polymer. From the viewpoint of improving the curability, the charge transport polymer preferably has a polymerizable functional group at the terminal portions. In one embodiment, the charge transport polymer (1) preferably contains a structural unit T1 having a structure represented by formula (I) below. In the formula, Ar, X, Y and Z are as described above.

-Ar-X-Y-Z (I)

By using a charge transport polymer (1) containing the above structural unit T1, excellent curability and heat resistance can be obtained with relative ease. The structural unit T1 preferably has a structure represented by at least one of formulas (1-1) and (1-2) shown above. The structural unit T1 more preferably has a structure of formula (1-3) shown above.

The charge transport polymer (1) may also have another monovalent structural unit that forms a different terminal portion from the structural unit T1, provided the charge transport properties and curability are not impaired.

In one embodiment, the charge transport polymer (1) may have a monovalent structural unit T2 having a structure represented by formula (I-T2) below, in addition to the structural unit T1 described above. When the charge transport polymer (1) has both the structural unit T1 and the structural unit T2, the heat resistance can be easily improved even further.

-Ar-J-R1 (I-T2)

In the above formula, Ar represents an arylene or heteroarylene group of 2 to 30 carbon atoms.

J represents a single bond, or a divalent linking group selected from the group consisting of an ester linkage (-COO-) and the groups (x1) to (x10) listed above as examples of the linking group X in the above formula (I).

R represents a linear, cyclic or branched alkyl group of 1 to 22 carbon atoms, or an aryl group of 6 to 30 carbon atoms.

Ar is preferably an arylene group of 6 to 30 carbon atoms. A phenylene group or naphthylene group is more preferred, and a phenylene group is even more preferred.

J is preferably a single bond, an ester linkage, or a linking group (-NR-) having a structure in which an additional hydrogen atom has been removed from an amino group. Here, R in the linking group (-NR-) is preferably a phenyl group.

In one embodiment, R1 in formula (I-T2) is a linear, cyclic or branched alkyl group of 1 to 22 carbon atoms, and the number of carbon atoms is more preferably from 2 to 16, even more preferably from 3 to 12, and particularly preferably from 4 to 8.

In order to improve the heat resistance of the charge transport polymer, the proportion of cyclic structures within the molecule is preferably increased. From this type of viewpoint, R1 in formula (I-T2) is preferably a cyclic alkyl group (cycloalkyl group) of 3 to 30 carbon atoms. The number of carbon atoms is more preferably from 5 to 20, and even more preferably from 6 to 15. The cycloalkyl group may be saturated or unsaturated, but is preferably saturated. Further, the cyclic group may have a structure that is either monocyclic or polycyclic, but preferably has a polycyclic structure. Specific examples of R1 include an adamantyl group and the like.

In another embodiment, R1 in formula (I-T2) is preferably an aryl group of 6 to 30 carbon atoms, is more preferably a phenyl group or a naphthyl group, and is even more preferably a phenyl group.

Although not a particular limitation, in one embodiment, the structural unit T2 preferably has a structure in which J represents an ester linkage and R1 represents a cycloalkyl group in the above formula (I-T2).

In one embodiment, from the viewpoint of improving both the curability and the heat resistance of the charge transport polymer (1), the proportion of the structural units T1 having a structure represented by formula (I), relative to the total of all the structural units T, is preferably at least 50 mol%, more preferably at least 75 mol%, and even more preferably 85 mol% or greater. This proportion of the structural unit T1 may be set to 100 mol%.

In one embodiment, from the viewpoint of improving the heat resistance of the charge transport polymer (1), when a structural unit T2 is used in addition to the structural unit T1, the proportion of the structural units T2, relative to the total of all the structural units T (T1+T2), is preferably not more than 75 mol%, more preferably not more than 50 mol%, and even more preferably 25 % or less. On the other hand, the proportion of the structural unit T1 is preferably at least 25 mol%, more preferably 50 mol%, and even more preferably 75 mol% or greater. By adjusting the proportions of the structural units T1 and T2 so as to fall within the above ranges, the heat resistance can be further improved without impairing the curability.

The preferred number of polymerizable functional groups per one molecule of the charge transport polymer is as described above, and the number of polymerizable functional groups in the charge transport polymer (1) means the total of the polymerizable functional group Z contained in the structural region represented by formula (I) and any other polymerizable functional groups.

The number average molecular weight of the charge transport polymer (1) may be adjusted appropriately with due consideration of the solubility in solvents and the film formability and the like. From the viewpoint of ensuring superior charge transport properties, the number average molecular weight is preferably at least 500, more preferably at least 1,000, even more preferably 2,000 or greater. Further, from the viewpoints of maintaining favorable solubility in solvents and facilitating the preparation of ink compositions, the number average molecular weight is preferably not more than 1,000,000, more preferably not more than 100,000, and even more preferably 50,000 or less.

The weight average molecular weight of the charge transport polymer (1) may be adjusted appropriately with due consideration of the solubility in solvents and the film formability and the like. From the viewpoint of ensuring superior charge transport properties, the weight average molecular weight is preferably at least 1,000, more preferably at least 5,000, and even more preferably 10,000 or greater. Further, from the viewpoints of maintaining favorable solubility in solvents and facilitating the preparation of ink compositions, the weight average molecular weight is preferably not more than 1,000,000, more preferably not more than 700,000, and even more preferably 400,000 or less.

### [Charge Transport Compound (2)]

In one embodiment, the charge transport material (organic electronic material) contains a charge transport compound (hereafter also referred to as the "charge transport compound (2)") having a specific structural region represented by formula (II) shown below.

-Ar-Y-Z (II)

In the formula, Ar represents an arylene group or heteroarylene group of 2 to 30 carbon atoms, Y represents a divalent group derived from an aliphatic hydrocarbon of 1 to 10 carbon atoms, and Z represents a substituted or unsubstituted polymerizable functional group.

In the above charge transport material, the polymerizable functional group Z preferably is preferably a substituted or unsubstituted oxetane group, epoxy group, vinyl group, acryloyl group or methacryloyl group.

In the above charge transport material, the structural region represented by formula (II) preferably has a structure represented by formula (II-1) below. In the formula, n represents an integer of 3 to 10, and Z represents a substituted or unsubstituted oxetane group, vinyl group or epoxy group.

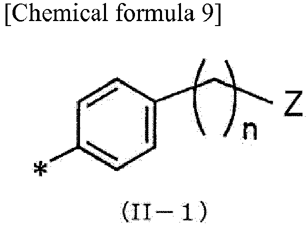

In the above charge transport material, the thermal weight reduction of the charge transport compound (2) upon heating at 300°C in the open atmosphere is preferably not more than 5%.

In the above charge transport material, the increase in drive voltage (V₂-V₁), determined from a drive voltage V₁ and a drive voltage V₂ described below, is preferably not more than 1 V.

Drive voltage V₁: the voltage at a current density of 300 mA/cm for a first organic layer obtained using the above charge transport material by heating at 200°C over a period of 30 minutes.

Drive voltage V₂: the voltage at a current density of 300 mA/cm for a second organic layer obtained using the same charge transport material as that used for the above first layer, by heating at 200°C over a period of 30 minutes, and then heating at 230°C over a period of 30 minutes.

In the above charge transport material, the dissolution time required to form a 1% toluene solution of the charge transport compound (2) at 25°C is preferably not longer than 10 minutes.

In the above charge transport material, the charge transport compound (2) is preferably a hole injection compound.

In the above charge transport material, the charge transport compound (2) preferably contains a divalent structural unit L having charge transport properties and a trivalent or higher structural unit B having charge transport properties.

In the above charge transport material, the above structural units having charge transport properties preferably contain at least one structure selected from the group consisting of aromatic amine structures, pyrrole structures, carbazole structures, thiophene structures, benzene structures, phenoxazine structures and fluorene structures.

In the above charge transport material, the charge transport compound (2) is preferably a charge transport polymer.

In the above charge transport material, the charge transport polymer preferably has a structural region represented by the above formula (II) at a terminal.

This charge transport material may have two or more types of the above charge transport compound (2), and may also contain one or more other charge transport compounds.

The charge transport compound (2) has one or more structural units having charge transport properties, and at least one of those structural units contains a structural region represented by formula (II).

In the above formula (II), Ar represents an arylene group or heteroarylene group of 2 to 30 carbon atoms. An arylene group means a group having a structure in which two hydrogen atoms have been removed from an aromatic hydrocarbon. A heteroarylene group means a group having a structure in which two hydrogen atoms have been removed from an aromatic heterocycle. The aromatic hydrocarbon and the aromatic heterocycle may each have a single ring structure such as benzene, or may have a condensed ring structure having rings condensed together such as naphthalene.

Specific examples of the aromatic hydrocarbon include benzene, naphthalene, anthracene, tetracene, fluorene and phenanthrene. Specific examples of the aromatic heterocycle include pyridine, pyrazine, quinoline, isoquinoline, acridine, phenanthroline, furan, pyrrole, thiophene, carbazole, oxazole, oxadiazole, thiadiazole, triazole, benzoxazole, benzoxadiazole, benzothiadiazole, benzotriazole and benzothiophene.

The aromatic hydrocarbon and the aromatic heterocycle may have a polycyclic structure in which two or more structures selected from among monocyclic structures and condensed ring structures are bonded together via a single bond. Examples of aromatic hydrocarbons having this type of structure include biphenyl, terphenyl and triphenylbenzene. The aromatic hydrocarbon and the aromatic heterocycle may each be either unsubstituted, or have one or more substituents. The substituent may, for example, be a linear, cyclic or branched alkyl group of 1 to 22 carbon atoms. This number of carbon atoms is preferably from 1 to 15, more preferably from 1 to 12, and even more preferably from 1 to 6. In one embodiment, Ar is preferably a phenylene group or a naphthylene group, and is more preferably a phenylene group.

In the above formula (II), Y is a divalent group (linking group) derived from an aliphatic hydrocarbon group of 1 to 10 carbon atoms. The linking group may be linear, branched or cyclic, or have a combination of these structures. The linking group may be saturated or unsaturated. In one embodiment, from the viewpoint of the ease of availability of the monomer, the linking group preferably has a linear structure. Furthermore, a saturated linear structure is more preferred.

From the above viewpoint, Y in the above formula (II) is preferably -(CH₂)ₙ-, and in this formula, n is preferably an integer from 1 to 10, more preferably an integer from 1 to 8, and even more preferably an integer from 1 to 7.

In the above formula (II), Z represents a polymerizable functional group. The "polymerizable functional group" is as described above in the section relating to the charge transport polymer.

In one embodiment, from the viewpoint of the storage stability, the polymerizable functional group Z is preferably a substituted or unsubstituted oxetane group represented by formula (z1) below. In the formula, R represents a hydrogen atom or a saturated alkyl group of 1 to 4 carbon atoms. It is particularly preferable that R represents a methyl group or an ethyl group.

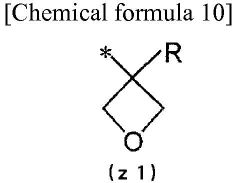

The charge transport compound (2) having at least one structural region represented by the above formula (II) contains at least one polymerizable functional group Z within the structure. Compounds containing the polymerizable functional group can be cured by a polymerization reaction, and as a result of the curing, the solubility in solvents can be changed. Accordingly, the charge transport compound (2) is a material that exhibits excellent curability and is suited to wet processes.

In one embodiment, the structural region represented by the above formula (II) preferably has a structure represented by formula (II-1) below.

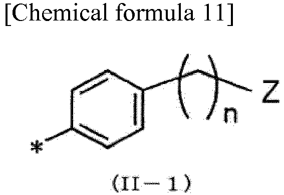

In the formula, Z is the aforementioned polymerizable functional group, and is preferably a substituted or unsubstituted oxetane group, vinyl group or epoxy group. Further, n represents an integer of 1 to 10. From the viewpoints of the heat resistance and the solubility, n is preferably not more than 10, and more preferably 8 or less.

Furthermore, n is also preferably not more than 10 from the viewpoint of the ease of availability of the raw material monomer. In one embodiment, n is preferably an integer from 1 to 8, and more preferably an integer from 1 to 7.

The charge transport compound (2) may be any compound that has a structural region represented by the above formula (II) and has the ability to transport an electric charge. In one embodiment, the transported charge is preferably a positive hole. If the compound has hole transport properties, then the compound can be used, for example, for a hole injection layer or a hole transport layer in an organic EL element. Further, if the compound has electron transport properties, then the compound can be used for an electron transport layer or an electron injection layer. Furthermore, if the compound is able to transport both holes and electrons, then the compound can be used as the material of a light-emitting layer or the like. In one embodiment, the charge transport compound (2) is preferably used as the material for at least one of a hole injection layer and a hole transport layer, and is more preferably used as a hole injection layer material.

In one embodiment, from the viewpoint of the heat resistance, the charge transport compound (2) preferably has a thermal weight reduction upon heating at 300°C of not more than 5% by mass relative to the mass prior to heating. The thermal weight reduction is more preferably not more than 3.5% by mass. Moreover, in order of increasing preference, the thermal weight reduction is more preferably not more than 3.0% by mass, not more than 2.5% by mass, or not more than 1.5% by mass, and is most preferably 1.0% by mass or less. In those cases where a charge transport polymer (hereafter also referred to as the "charge transport polymer (2)") containing a structural region of the above formula (II) is used as the charge transport compound (2), the thermal weight reduction for the material can be easily adjusted to a value within the above range.

In those cases where the charge transport compound has excellent heat resistance, thermal degradation, for example during organic film formation, is suppressed, and an organic layer having excellent conductivity can be easily obtained. Further, by suppressing deterioration in the conductivity of the organic layer caused by thermal degradation, increases in the drive voltage of the element can be easily suppressed, and other element characteristics such as the lifespan characteristics can be improved.

An increase in the drive voltage can be evaluated, for example, on the basis of the increase in drive voltage (V₂-V₁) determined by the difference between a drive voltage V₁ and a drive voltage V₂ described below.

Drive voltage V₁: the voltage at a current density of 300 mA/cm for a first organic layer obtained using the above charge transport material by heating at 200°C over a period of 30 minutes.

Drive voltage V₂: the voltage at a current density of 300 mA/cm for a second organic layer obtained using the same charge transport material as that used for the above first layer, by heating at 200°C over a period of 30 minutes, and then heating at 230°C over a period of 30 minutes.

Measurement of the voltages for the first and second organic layers described above can be performed using samples obtained by sequentially forming the first organic layer or second organic layer (thickness: 100 nm, respectively), an α-NPD layer (thickness: 20 nm) and an Al electrode (thickness: 100 nm) on top of a glass substrate on which ITO has been patterned.

In one embodiment, from the viewpoint of improving the lifespan characteristics of the element, the above increase in the drive voltage (V₂-V₁) is preferably not more than 1 V. This increase in the drive voltage is more preferably not more than 0.9 V, even more preferably not more than 0.8 V, and particularly preferably 0.7 V or less.

In this regard, when a charge transport material containing the charge transport compound (2) described above is used for forming the first organic layer and second organic layer described above, the above increase in drive voltage can be suppressed to a value within the above preferred range, enabling an improvement in the lifespan characteristics of the element.

In order to enable film formation by wet processes to be performed more easily, the charge transport material preferably exhibits excellent solubility in the ink solvent during ink preparation. Provided the solubility of the charge transport material in the ink solvent can be improved, the time required for ink preparation can be reduced, enabling a reduction in takt time and a reduction in costs.

From the viewpoint of obtaining superior solubility in ink solvents, n in the structural region represented by the above formula (II-1) is preferably an integer of 3 or greater, and more preferably an integer of 4 or greater. Accordingly, in one embodiment, n is preferably from 3 to 10, more preferably from 3 to 8, and even more preferably from 4 to 7. When n falls within this range, in addition to excellent heat resistance, excellent solubility can be easily obtained.

From the viewpoint of the storage stability, in specific examples of the structural region represented by the above formula (II-1), Z is preferably a substituted or unsubstituted oxetane group. In such cases, from the viewpoint of achieving a combination of excellent heat resistance and excellent solubility, from 3 to 6 is preferable. Among such compounds, from the viewpoint of the ease of availability of the raw material monomer, n is more preferably either 3 or 4.

Further, in one embodiment, from the viewpoint of obtaining superior solubility, the dissolution time required to form a 1% toluene solution of the charge transport compound (2) at room temperature (25°C) in the open atmosphere is preferably not longer than 10 minutes. In other words, when 10 mg of the charge transport compound (2) is added to 1.145 mL of toluene, the dissolution time for the charge transport compound (2) is preferably not longer than 10 minutes. This dissolution time is preferably not longer than 9 minutes, and more preferably 8 minutes or shorter. Here, the dissolution time means the time required, based on visual inspection, for the charge transport compound (2) to dissolve in the toluene to form a transparent solution. In the structural region represented by the above formula (II-1), when n falls within the above range, a favorable dissolution time can be achieved with relative ease.

As described above, the charge transport compound (2) has either one, or two or more, structural units having charge transport properties, and at least one of those structural units has a structural region represented by the above formula (II). In one embodiment, the charge transport compound (2) preferably has a structure that is branched in three or more directions.

In one embodiment, the charge transport compound (2) is a charge transport polymer, and this charge transport polymer (2) has an aforementioned structural region represented by formula (II) below within the molecule, and has the ability to carry charge.

-Ar-Y-Z (II)

Charge transport polymers containing a structural region represented by -Ar-CH₂-O- at a terminal portion readily undergo intramolecular bond cleavage upon heating, and tend to have poor heat resistance. In contrast, the charge transport polymer (2) is resistant to intramolecular bond cleavage upon heating, and has excellent heat resistance. Accordingly, by forming an organic electronic material containing this type of charge transport polymer (2), the heat resistance of the material can be improved.

As the heat resistance improves, the degree of thermal degradation of the organic layer in high-temperature processes, for example during element production, is improved, making it easier to maintain the performance of the organic layer. In particular, in those cases where an organic layer is formed by a coating method using a charge transport material containing the charge transport polymer (2) having a structural region represented by the above formula (II), deterioration in the performance of the organic layer is suppressed, even during high-temperature baking treatments, meaning superior carrier mobility can be maintained. In other words, the degree of thermal degradation during element production is improved, and deterioration in conductivity can be suppressed. Further, by improving the heat resistance and conductivity of the organic layer formed from the charge transport polymer, the heat resistance, conductivity and lifespan characteristics of the element can be improved.

The structural region represented by the above formula (II) may be introduced at a terminal portion of the charge transport polymer (2) (namely, an aforementioned structural unit T), at a portion other than a terminal portion (namely, a structural unit L or B), or at both a terminal portion and a portion other than a terminal. From the viewpoint of the curability, the structural region is preferably introduced at least at a terminal portion, and from the viewpoint of achieving a combination of favorable curability and charge transport properties, is preferably introduced only at terminal portions. Further, in those cases where the charge transport polymer (2) has a branched structure, the structural region represented by formula (II) may be introduced within the main chain of the charge transport polymer (2), within a side chain, or within both the main chain and a side chain.

Based on the viewpoint that the charge transport polymer preferably has a polymerizable functional group at a terminal in order to improve the curability, in one embodiment, the charge transport polymer (2) preferably has a structural region represented by the above formula (II) as a structural unit T1 at a terminal. By using a charge transport polymer (2) containing the structural unit T1, excellent curability and heat resistance can be easily obtained. It is even more preferable that the charge transport polymer (2) has a structural region represented by the above formula (II-1) as the structural unit T1.

In one embodiment, from the viewpoint of improving both the curability and the heat resistance of the charge transport polymer (2), the proportion of the structural unit T1 having a structural region represented by the above formula (II), relative to the total of all the structural units T, is preferably at least 50 mol%, more preferably at least 75 mol%, and even more preferably 85 mol% or greater. This proportion of the structural unit T1 maybe 100 mol%.

The preferred number of polymerizable functional groups per one molecule of the charge transport polymer is as described above, and in the charge transport polymer (2), the number of polymerizable functional groups means the total of the polymerizable functional group Z contained in the structural region represented by formula (II), and any other polymerizable functional groups.

The number average molecular weight of the charge transport polymer (2) may be adjusted appropriately with due consideration of the solubility in solvents and the film formability and the like. From the viewpoint of achieving superior charge transport properties, the number average molecular weight is preferably at least 500, more preferably at least 1,000, and even more preferably 2,000 or greater. Further, from the viewpoints of maintaining favorable solubility in solvents and facilitating the preparation of ink compositions, the number average molecular weight is preferably not more than 1,000,000, more preferably not more than 100,000, and even more preferably 50,000 or less.

The weight average molecular weight of the charge transport polymer (2) may be adjusted appropriately with due consideration of the solubility in solvents and the film formability and the like. From the viewpoint of achieving superior charge transport properties, the weight average molecular weight is preferably at least 1,000, more preferably at least 5,000, and even more preferably 10,000 or greater. Further, from the viewpoints of maintaining favorable solubility in solvents and facilitating the preparation of ink compositions, the weight average molecular weight is preferably not more than 1,000,000, more preferably not more than 700,000, and even more preferably 400,000 or less.

### [Charge Transport Polymer (3)]

In one embodiment, the charge transport material (organic electronic material) contains at least one charge transport compound (hereafter also referred to as the "charge transport compound (3)") having at least one of the structural regions represented by formulas (III-1), (III-2) and (III-3) shown below.

-Ar-O-(CH₂)ₐ-O-CH₂-Z (III-1)

-Ar-(CH₂)_{b}-O-CH₂-Z (III-2)

-Ar-O-(CH₂)_{c}-Z (III-3)

In the formulas, Ar represents an arylene group or heteroarylene group of 2 to 30 carbon atoms, and a, b and c each represent a number of carbon atoms in the methylene chain (-CH₂-), wherein a is an integer from 1 to 6, b is an integer from 2 to 6, and c is an integer from 2 to 6. Z represents a substituted or unsubstituted polymerizable functional group.

In the above charge transport material, the polymerizable functional group preferably contains at least one group selected from the group consisting of substituted and unsubstituted oxetane groups, epoxy groups, vinyl groups, acryloyl groups and methacryloyl groups.

In the charge transport material, the charge transport compound (3) is preferably a hole injection compound.

In the above charge transport material, the charge transport compound (3) preferably contains at least one structure selected from the group consisting of aromatic amine structures, carbazole structures, thiophene structures, benzene structures, phenoxazine structures and fluorene structures.

In the above charge transport material, the charge transport compound (3) is preferably a charge transport polymer, and preferably has at least one structural region represented by one of the above formulas (III-1), (III-2) and (III-3) at a terminal of the charge transport polymer.

In the above charge transport material, the charge transport compound (3) preferably has a structure that is branched in three or more directions.

In the above charge transport material, the thermal weight reduction of the charge transport compound (3) upon heating at 300°C in the open atmosphere is preferably not more than 5%.

The above charge transport material may contain two or more types of the charge transport compound (3), and may also contain other charge transport compounds.

The charge transport compound (3) is a compound having one or more structural units having charge transport properties, wherein at least one of those structural units has at least one structural region represented by one of the above formulas (III-1), (III-2) and (III-3) (hereafter, these formulas are also jointly referred to as "formula (III)"). The structural region represented by formula (III) has a specific structure formed from an ether linkage and an alkylene chain in the linking portion between the Ar group and the polymerizable functional group Z.

Charge transport polymers containing a structural region represented by -Ar-CH₂-O- at a terminal portion readily undergo intramolecular bond cleavage upon heating, and tend to have poor heat resistance. In contrast, the charge transport polymer (3) is resistant to intramolecular bond cleavage upon heating, and therefore has excellent heat resistance. Further, this charge transport compound (3) also exhibits excellent solubility in a coating solvent such as toluene. Accordingly, by forming a charge transport material containing the above charge transport polymer (3), a combination of excellent heat resistance and excellent solubility can be achieved.

In one embodiment, from the viewpoint of the heat resistance, the charge transport compound (3) preferably has a thermal weight reduction upon heating at 300°C of not more than 6% by mass relative to the mass prior to heating. The thermal weight reduction is more preferably not more than 5% by mass, and even more preferably 3.5% by mass or less.

Each of the structural regions represented by the above formula (III) are described below in further detail.

Ar represents an arylene group or heteroarylene group of 2 to 30 carbon atoms. An arylene group means a group having a structure in which two hydrogen atoms have been removed from an aromatic hydrocarbon. A heteroarylene group means a group having a structure in which two hydrogen atoms have been removed from an aromatic heterocycle. The aromatic hydrocarbon and the aromatic heterocycle may each have a single ring structure such as benzene, or may have a condensed ring structure having rings condensed together such as naphthalene.

Specific examples of the aromatic hydrocarbon include benzene, naphthalene, anthracene, tetracene, fluorene and phenanthrene. Specific examples of the aromatic heterocycle include pyridine, pyrazine, quinoline, isoquinoline, acridine, phenanthroline, furan, pyrrole, thiophene, carbazole, oxazole, oxadiazole, thiadiazole, triazole, benzoxazole, benzoxadiazole, benzothiadiazole, benzotriazole, and benzothiophene.

The aromatic hydrocarbon and the aromatic heterocycle may also have a polycyclic structure in which two or more aromatic structures selected from among monocyclic and condensed ring structures are bonded together via a single bond. Examples of aromatic hydrocarbons having this type of polycyclic structure include biphenyl, terphenyl and triphenylbenzene. The aromatic hydrocarbon and the aromatic heterocycle may each be unsubstituted, or have one or more substituents. The substituent may, for example, be a linear, cyclic or branched alkyl group of 1 to 22 carbon atoms. This number of carbon atoms is more preferably from 1 to 15, even more preferably from 1 to 12, and particularly preferably from 1 to 6. In one embodiment, Ar is preferably a phenylene group or a naphthylene group, and is more preferably a phenylene group.

In the structural region represented by formula (III), Z represents a polymerizable functional group. The "polymerizable functional group" is as described above in the section relating to the charge transport polymer.

In one embodiment, from the viewpoint of the storage stability, the polymerizable functional group Z is preferably a substituted or unsubstituted oxetane group represented by formula (z1) below. In the formula, R represents a hydrogen atom or a saturated alkyl group of 1 to 4 carbon atoms. It is particularly preferable that R represents a methyl group or an ethyl group.

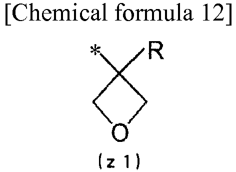

The charge transport compound (3) having at least one structural region represented by the above formula (III) contains at least one polymerizable functional Z group within the structure. Compounds containing the polymerizable functional group can be cured by a polymerization reaction, and as a result of the curing, the solubility in solvents can be changed. Accordingly, the charge transport compound (3) is a material that exhibits excellent curability and is suited to wet processes.

Specific examples of the structural region represented by any one of the above formulas (III-1), (III-2) and (III-3) are shown below.

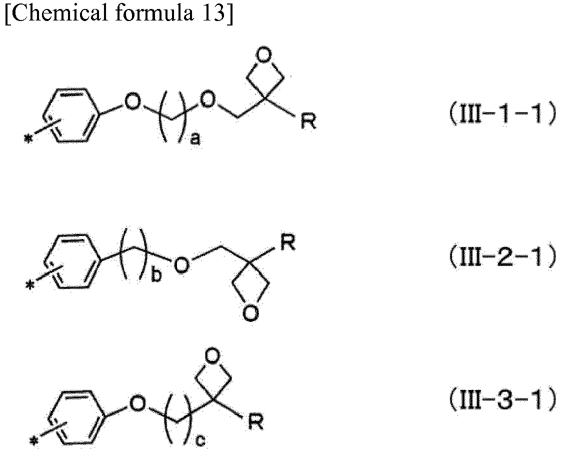

In the above formulas, a is preferably an integer of 1 to 6, preferably an integer of 2 to 6, and more preferably an integer of 4 to 6. Further, b is preferably an integer of 2 to 6, more preferably an integer of 3 to 6, and even more preferably an integer of 4 to 6. Moreover, c is preferably an integer of 2 to 6, more preferably an integer of 3 to 6, and even more preferably a number of 4 to 6.

The charge transport compound (3) may be any compound that has a structural region represented by the above formula (III) and has the ability to transport an electric charge. The transported charge is preferably a positive hole. If the compound has hole transport properties, then the compound can be used, for example, for a hole injection layer or a hole transport layer in an organic EL element, whereas if the compound has electron transport properties, then the compound can be used for an electron transport layer or an electron injection layer. Furthermore, if the compound is able to transport both holes and electrons, then the compound can be used as the material of a light-emitting layer.

In one embodiment, the charge transport compound (3) is a charge transport polymer (hereafter also referred to as the "charge transport polymer (3)") that has the ability to transport an electric charge, and has at least one structural region represented by one of the above formulas (III-1), (III-2) and (III-3).

The one or more structural regions represented by the above formula (III) may be introduced at a terminal of the charge transport polymer (3) (namely, an aforementioned structural unit T), at a portion other than a terminal (namely, a structural unit L or B), or at both a terminal and a portion other than a terminal. From the viewpoint of the curability, the structural region is preferably introduced at least at a terminal portion, and from the viewpoint of achieving a combination of favorable curability and charge transport properties, is preferably introduced only at terminal portions. Further, in those cases where the charge transport polymer has a branched structure, the above structural region may be introduced within the main chain of the charge transport polymer (3), within a side chain, or within both the main chain and a side chain.

Based on the viewpoint that the charge transport polymer preferably has a polymerizable functional group at a terminal in order to improve the curability, in one embodiment, the charge transport polymer (3) preferably has, as a structural unit T1, at least one structural region represented by one of the above formulas (III-1), (III-2) and (III-3), and more preferably has at least one structural region represented by one of the above formulas (III-1-1), (III-2-1) and (III-3-1).

In one embodiment, from the viewpoint of improving both the heat resistance and the solubility of the charge transport polymer (3), the proportion of the structural region represented by the above formula (III) (the structural unit T1), relative to the total of all the structural units T, is preferably at least 50 mol%, more preferably at least 75 mol%, and even more preferably 85 mol% or greater. This proportion of the structural unit T1 maybe 100 mol%.

The number average molecular weight of the charge transport polymer (3) may be adjusted appropriately with due consideration of the solubility in solvents and the film formability and the like. From the viewpoint of achieving superior charge transport properties, the number average molecular weight is preferably at least 500, more preferably at least 1,000, and even more preferably 2,000 or greater. Further, from the viewpoints of maintaining favorable solubility in solvents and facilitating the preparation of ink compositions, the number average molecular weight is preferably not more than 1,000,000, more preferably not more than 100,000, and even more preferably 50,000 or less.

The weight average molecular weight of the charge transport polymer (3) may be adjusted appropriately with due consideration of the solubility in solvents and the film formability and the like. From the viewpoint of achieving superior charge transport properties, the weight average molecular weight is preferably at least 1,000, more preferably at least 5,000, and even more preferably 10,000 or greater. Further, from the viewpoints of maintaining favorable solubility in solvents and facilitating the preparation of ink compositions, the weight average molecular weight is preferably not more than 1,000,000, more preferably not more than 700,000, and even more preferably 400,000 or less.

The preferred number of polymerizable functional groups per one molecule of the charge transport polymer is as described above, and in the charge transport polymer (3), the number of polymerizable functional groups means the total of the polymerizable functional group Z contained in the structural region represented by formula (III), and any other polymerizable functional groups.

### <Ink Composition>

In one embodiment, an ink composition contains the charge transport material of an embodiment described above, and a solvent capable of dissolving or dispersing the material. By using the ink composition, an organic layer can be formed easily using a simple coating method.

### [Solvent]

Water, organic solvents, or mixed solvents thereof can be used as the solvent. Examples of the organic solvent include alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amide-based solvents such as N,N-dimethylformamide and N,N-dimethylacetamide; as well as dimethyl sulfoxide, tetrahydrofuran, acetone, chloroform and methylene chloride and the like. Preferred solvents include aromatic hydrocarbons, aliphatic esters, aromatic esters, aliphatic ethers, and aromatic ethers and the like.

### [Polymerization Initiator]

In those cases where the charge transport polymer has a polymerizable functional group, the ink composition preferably contains a polymerization initiator. Known radical polymerization initiators, cationic polymerization initiators, and anionic polymerization initiators and the like can be used as the polymerization initiator. From the viewpoint of enabling simple preparation of the ink composition, the use of a substance that exhibits both a function as a dopant and a function as a polymerization initiator is preferred. Examples of such substances include the ionic compounds described above.

In other words, an onium salt described above can be used favorably as a cationic polymerization initiator that also functions as a dopant. Examples include salts of a perfluoro anion and a cation such as an iodonium ion or an ammonium ion.

Specifically, the ionic compounds disclosed in WO 2013/081052 may be used. Among those compounds, the use of ammonium borate compounds is preferred.

### [Additives]

The ink composition may also contain additives as optional components. Examples of these additives include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

### [Contents]

The amount of the solvent in the ink composition can be determined with due consideration of the use of the composition in various application methods. For example, the amount of the solvent is preferably an amount that yields a ratio of the charge transport polymer relative to the solvent that is at least 0.1% by mass, more preferably at least 0.2% by mass, and even more preferably 0.5% by mass or greater. Further, the amount of the solvent is preferably an amount that yields a ratio of the charge transport polymer relative to the solvent that is not more than 20% by mass, more preferably not more than 15% by mass, and even more preferably 10% by mass or less.

### <Organic Layer>

In one embodiment, an organic layer is a layer formed using the charge transport material or the ink composition of an embodiment described above, and is a layer that contains the charge transport material of the above embodiment. By using the ink composition, an organic layer can be formed favorably by a coating method. Examples of the coating method include known methods such as spin coating methods, casting methods, dipping methods, plate-based printing methods such as relief printing, intaglio printing, offset printing, lithographic printing, relief reversal offset printing, screen printing and gravure printing, and plateless printing methods such as inkjet methods. When the organic layer is formed by a coating method, the organic layer (coating layer) obtained following coating may be dried using a hotplate or an oven to remove the solvent.

In those cases where the charge transport polymer has a polymerizable functional group, the charge transport polymer can be subjected to a polymerization reaction by performing light irradiation or a heat treatment or the like, thereby changing the solubility of the organic layer. By stacking organic layers having changed solubility levels, multilayering of an organic electronic element can be performed with ease. Reference may also be made to WO 2010/140553 in relation to the method used for forming the organic layer. The charge transport polymer of the embodiment described above can be subjected to a heat treatment at a temperature exceeding 200°C (also referred to as high-temperature baking), and thermal degradation following the heat treatment can be suppressed.

From the viewpoint of improving the efficiency of charge transport, the thickness of the organic layer obtained following drying or curing is preferably at least 0.1 nm, more preferably at least 1 nm, and even more preferably 3 nm or greater. Further, from the viewpoint of reducing the electrical resistance, the thickness of the organic layer is preferably not more than 300 nm, more preferably not more than 200 nm, and even more preferably 100 nm or less.

As a result of the improved heat resistance of the charge transport material of the embodiment described above, thermal degradation of the organic layer caused by high-temperature processes during element production can be suppressed, and therefore the performance of the organic layer can be easily maintained. Further, as a result of the improved solubility of the charge transport compound, the charge transport material becomes a material that is suitable for wet processes. In particular, when an organic layer is formed by a coating method using an organic electronic material containing any of the charge transport polymers (1) to (3) described above, the coating solution (ink composition) can be prepared efficiently, and even if high-temperature baking is performed following film formation, deterioration in the performance of the organic layer is suppressed, and superior carrier mobility can be maintained. As a result, thermal degradation during element production is improved, and deterioration in conductivity can be suppressed. Furthermore, by improving the heat resistance of the charge transport polymer, the drive voltage and the lifespan characteristics of the element can also be improved.

### <Organic Electronic Element>

In one element, an organic electronic element has at least one organic layer of the embodiment described above. Examples of the organic electronic element include an organic EL element, an organic photoelectric conversion element, and an organic transistor. The organic electronic element preferably has at least a structure in which an organic layer is disposed between a pair of electrodes.

### [Organic EL Element]

In one embodiment, an organic EL element has at least one organic layer of the embodiment described above. The organic EL element typically includes a light-emitting layer, an anode, a cathode and a substrate, and if necessary, may also have other functional layers such as a hole injection layer, electron injection layer, hole transport layer and electron transport layer. Each layer may be formed by a vapor deposition method, or by a coating method. The organic EL element preferably has the organic layer as the light-emitting layer or as another functional layer, more preferably has the organic layer as a functional layer, even more preferably has the organic layer as at least one of a hole injection layer and a hole transport layer, and most preferably has the organic layer as a hole injection layer.

FIG. 1 is a cross-sectional schematic view illustrating one embodiment of the organic EL element. The organic EL element in FIG. 1 is an element with a multilayer structure, and has a substrate 8, an anode 2, a hole injection layer 3 and a hole transport layer 6 each formed from an organic layer of the embodiment described above, a light-emitting layer 1, an electron transport layer 7, an electron injection layer 5 and a cathode 4 provided in that order. Each of these layers is described below.

### [Light-Emitting Layer]

Examples of the materials that can be used for the light-emitting layer include low-molecular weight compounds, polymers, and dendrimers and the like. Polymers exhibit good solubility in solvents, meaning they are suitable for coating methods, and are consequently preferred. Examples of the light-emitting material include fluorescent materials, phosphorescent materials, and thermally activated delayed fluorescent materials (TADF).

Specific examples of the fluorescent materials include low-molecular weight compounds such as perylene, coumarin, rubrene, quinacridone, stilbene, color laser dyes, aluminum complexes, and derivatives of these compounds; polymers such as polyfluorene, polyphenylene, polyphenylenevinylene, polyvinylcarbazole, fluorene-benzothiadiazole copolymers, fluorene-triphenylamine copolymers, and derivatives of these compounds; and mixtures of the above materials.

Examples of materials that can be used as the phosphorescent materials include metal complexes and the like containing a metal such as Ir or Pt or the like. Specific examples of Ir complexes include FIr(pic) (iridium(III) bis[(4,6-difluorophenyl)-pyridinato-N,C²]picolinate) which emits blue light, Ir(ppy)₃ (fac-tris(2-phenylpyridine)iridium) which emits green light, and (btp)₂Ir(acac) (bis[2-(2'-benzo[4,5-α]thienyl)pyridinato-N,C³]iridium(acetyl-acetonate)) and Ir(piq)₃ (tris(1-phenylisoqionoline)iridium) which emit red light. Specific examples of Pt complexes include PtOEP (2,3,7,8,12,13,17,18-octaethyl-21H,23H-porphyrin-platinum) which emits red light.

When the light-emitting layer contains a phosphorescent material, a host material is preferably also included in addition to the phosphorescent material. Low-molecular weight compounds, polymers, and dendrimers can be used as this host material. Examples of the low-molecular weight compounds include CBP (4,4'-bis(9H-carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds, whereas examples of the polymers include the charge transport material of the embodiment described above, polyvinylcarbazole, polyphenylene, polyfluorene, and derivatives of these polymers.

Examples of the thermally activated delayed fluorescent materials include the compounds disclosed in Adv. Mater., 21, 4802-4906 (2009); Appl. Phys. Lett., 98, 083302 (2011); Chem. Comm., 48, 9580 (2012); Appl. Phys. Lett., 101, 093306 (2012); J. Am. Chem. Soc., 134, 14706 (2012); Chem. Comm., 48, 11392 (2012); Nature, 492, 234 (2012); Adv. Mater., 25, 3319 (2013); J. Phys. Chem. A, 117, 5607 (2013); Phys. Chem. Chem. Phys., 15, 15850 (2013); Chem. Comm., 49, 10385 (2013); and Chem. Lett., 43, 319 (2014) and the like.

### [Hole Injection Layer, Hole Transport Layer]

The organic layer formed using the charge transport material described above is preferably used as at least one of a hole injection layer and a hole transport layer, and is more preferably used as at least a hole injection layer. As described above, by using an ink composition containing the charge transport material, these types of layers can be formed with ease. For example, in FIG.1, the hole injection layer 3 and the hole transport layer 6 are preferably organic layers formed using the type of charge transport material described above, but in another embodiment, the organic EL element is not limited to this type of structure, and other organic layers may be organic layers formed using the charge transport material described above.

In those cases where the organic EL element has an organic layer formed using the charge transport material described above as a hole transport layer, and also has a hole injection layer, a known material (such as triphenylamine) may be used for the hole injection layer. Further, in those cases where the organic EL element has an organic layer formed using the charge transport material described above as a hole injection layer, and also has a hole transport layer, a known material may be used for the hole transport layer. It is also preferable that the charge transport material of the embodiment described above is used for both the hole injection layer and the hole transport layer.

Examples of known materials that can be used for the hole injection layer and the hole transport layer include aromatic amine-based compounds (for example, aromatic diamines such as N,N'-di(naphthalen-1-yl)-N,N'-diphenyl-benzidine (α-NPD)), phthalocyanine-based compounds, and thiophene-based compounds (for example, thiophene-based conductive polymers (such as poly(3,4-ethylenedioxythiophene):poly(4-styrenesulfonate salt) (PEDOT:PSS) and the like).

### [Electron Transport Layer, Electron Injection Layer]

Examples of materials that can be used for the electron transport layer and the electron injection layer include phenanthroline derivatives, bipyridine derivatives, nitro-substituted fluorene derivatives, diphenylquinone derivatives, thiopyran dioxide derivatives, condensed-ring (such as naphthalene and perylene) tetracarboxylic acid anhydrides, carbodiimides, fluorenylidenemethane derivatives, anthraquinodimethane and anthrone derivatives, oxadiazole derivatives, thiadiazole derivatives, benzimidazole derivatives (for example, 2,2',2"-(1,3,5-benzenetriyl)tris(1-phenyl-1H-benzimidazole) (TPBi)), quinoxaline derivatives, and aluminum complexes (for example, aluminum bis(2-methyl-8-quinolinolate)-4-(phenylphenolate) (BAlq)). Further, the charge transport material of the embodiment described above may also be used.

### [Cathode]

Examples of the cathode material include metals or metal alloys, such as Li, Ca, Mg, Al, In, Cs, Ba, Mg/Ag, LiF and CsF.

### [Anode]

Metals (for example, Au) or other materials having conductivity can be used as the anode. Examples of the other materials include oxides (for example, ITO: indium oxide/tin oxide), and conductive polymers (for example, polythiophene-polystyrene sulfonic acid mixtures (PEDOT:PSS)).

### [Substrate]

Glass and plastics and the like can be used as the substrate. The substrate is preferably transparent, and a substrate having flexibility is preferred. Quartz glass and light-transmitting resin films and the like can be used favorably.

In one embodiment, the organic EL element preferably has a flexible substrate, and this flexible substrate preferably includes a resin film.

Examples of the resin films include films composed of polyethylene terephthalate, polyethylene naphthalate, polyethersulfone, polyetherimide, polyetheretherketone, polyphenylene sulfide, polyarylate, polyimide, polycarbonate, cellulose triacetate or cellulose acetate propionate.

In those cases where a resin film is used, an inorganic substance such as silicon oxide or silicon nitride may be coated onto the resin film to inhibit the transmission of water vapor and oxygen and the like.

### [Encapsulation]

The organic EL element may be encapsulated to reduce the effect of the outside atmosphere and extend the life of the element. Materials that can be used for the encapsulation include, but are not limited to, glass, plastic films such as epoxy resins, acrylic resins, polyethylene terephthalate and polyethylene naphthalate, and inorganic substances such as silicon oxide and silicon nitride.

There are also no particular limitations on the encapsulation method, and known methods may be used.

### [Emission Color]

There are no particular limitations on the color of the light emission from the organic EL element. White organic EL elements can be used for various illumination fixtures, including domestic lighting, in-vehicle lighting, watches and liquid crystal backlights, and are consequently preferred.

The method used for forming a white organic EL element may employ a method in which a plurality of light-emitting materials are used to emit a plurality of colors simultaneously, which are then mixed to obtain a white light emission. There are no particular limitations on the combination of the plurality of emission colors, and examples include combinations that include three maximum emission wavelengths for blue, green and red, and combinations that include two maximum emission wavelengths for blue and yellow, or for yellowish green and orange or the like. Control of the emission color can be achieved by appropriate adjustment of the types and amounts of the light-emitting materials.

### [Display Element, Illumination Device, Display Device]

In one embodiment, a display element contains the organic EL element of the embodiment described above. For example, by using the organic EL element as the element corresponding with each color pixel of red, green and blue (RGB), a color display element can be obtained. Examples of the image formation method include a simple matrix in which organic EL elements arrayed in a panel are driven directly by an electrode arranged in a matrix, and an active matrix in which a thin-film transistor is positioned on, and drives, each element.

In one embodiment, an illumination device contains the organic EL element of the embodiment described above. Moreover, in one embodiment, a display device contains the illumination device and a liquid crystal element as a display unit. For example, the display device may be a device that uses the illumination device of the embodiment described above as a backlight, and uses a known liquid crystal element as the display unit, namely a liquid crystal display device.

### EXAMPLES

The present invention is described below in further detail using a series of examples, but the present invention is not limited by the following examples. Unless specifically stated otherwise, "%" means "% by mass".

### [Example A: Examples 1 to 11]

### <1-1> Preparation of Charge Transport Polymers

### (Preparation of Pd Catalyst)

In a glove box under a nitrogen atmosphere and at room temperature, tris(dibenzylideneacetone)dipalladium (Pd₂(dba)₃, 73.2 mg, 80 µmol) was weighed into a sample tube, anisole (15 ml) was added, and the resulting mixture was agitated for 30 minutes. In a similar manner, tris(t-butyl)phosphine (129.6 mg, 640 µmol) was weighed into a sample tube, anisole (5 ml) was added, and the resulting mixture was agitated for 5 minutes. The two solutions were then mixed together and stirred for 30 minutes at room temperature to obtain a catalyst solution. All the solvents used in the catalyst preparation were deaerated by nitrogen bubbling for at least 30 minutes prior to use.

### (Charge Transport Polymer 1)

A charge transport polymer 1 was prepared in the following manner.

A three-neck round-bottom flask was charged with a monomer 1 shown below (4.0 mmol), a monomer 2 shown below (5.0 mmol), a monomer 3 shown below (2.0 mmol) and anisole (20 ml), and the prepared Pd catalyst solution (7.5 ml) was then added and stirred. After stirring for 30 minutes, a 10% aqueous solution of tetraethylammonium hydroxide (20 ml) was added. The resulting mixture was heated and refluxed for 2 hours. All the operations up to this point were conducted under a stream of nitrogen. Further, all of the solvents were deaerated by nitrogen bubbling for at least 30 minutes prior to use.

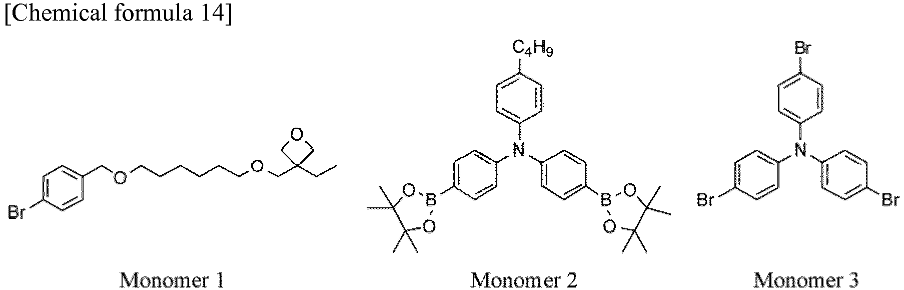

After completion of the reaction, the organic layer was washed with water. The organic layer was then poured into methanol-water (9:1). The resulting precipitate was collected by filtration under reduced pressure, and washed with methanol-water (9:1). The washed precipitate was dissolved in toluene, and re-precipitated from methanol. The thus obtained precipitate was collected by filtration under reduced pressure and then dissolved in toluene, and "Triphenylphosphine, polymer-bound on styrenedivinylbenzene copolymer" (manufactured by Strem Chemicals Inc., 200 mg per 100 mg of the polymer, hereafter referred to as a "metal adsorbent") was then added to the solution and stirred overnight.

Following completion of the stirring, the metal adsorbent and other insoluble matter were removed by filtration, and the filtrate was concentrated using a rotary evaporator. The concentrate was dissolved in toluene, and then re-precipitated from methanol-acetone (8:3). The thus produced precipitate was collected by filtration under reduced pressure and washed with methanol-acetone (8:3). The thus obtained precipitate was then dried under vacuum to obtain a charge transport polymer 1.

The thus obtained charge transport polymer 1 had a number average molecular of 7,800 and a mass average molecular weight of 31,000.

The number average molecular weight and the mass average molecular weight were measured by GPC (relative to polystyrene standards) using tetrahydrofuran (THF) as the eluent. The measurement conditions were as follows (with the same conditions also used in the following examples besides Example A).
Feed pump: L-6050, manufactured by Hitachi High-Technologies Corporation
UV-Vis detector: L-3000, manufactured by Hitachi High-Technologies Corporation
Columns: Gelpack (a registered trademark) GL-A160S / GL-A150S, manufactured by Hitachi Chemical Co., Ltd.
Eluent: THF (for HPLC, stabilizer-free), manufactured by Wako Pure Chemical Industries, Ltd.
Flow rate: 1 ml/min
Column temperature: room temperature
Molecular weight standards: standard polystyrenes

### (Charge Transport Polymer 2)

A charge transport polymer 2 was prepared in the following manner.

A three-neck round-bottom flask was charged with the monomer 2 shown above (5.0 mmol), the monomer 3 shown above (2.0 mmol), a monomer 4 shown below (4.0 mmol) and anisole (20 ml), and the prepared Pd catalyst solution (7.5 ml) was then added and stirred. Thereafter, the same method as that described for the charge transport polymer 1 was used to prepare a charge transport polymer 2. The thus obtained charge transport polymer 2 had a number average molecular of 22,900 and a mass average molecular weight of 169,000.

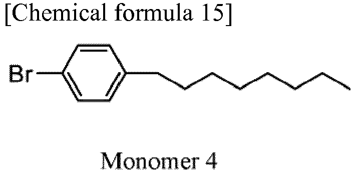

### (Charge Transport Polymer 3)

With the exception of replacing the monomer 1 (4.0 mmol) with the monomer 1 (1.0 mmol) and a monomer 5 shown below (3.0 mmol), the same method as the charge transport polymer 1 was used to prepare a charge transport polymer 3.

The thus obtained charge transport polymer 3 had a number average molecular of 13,384 and a mass average molecular weight of 63,790.

### (Charge Transport Polymer 4)

With the exception of replacing the monomer 1 (4.0 mmol) with the monomer 1 (1.0 mmol) and a monomer 6 shown below (3.0 mmol), the same method as the charge transport polymer 1 was used to prepare a charge transport polymer 4. The thus obtained charge transport polymer 4 had a number average molecular of 12,757 and a mass average molecular weight of 68,501.

### (Charge Transport Polymer 5)

With the exception of replacing the monomer 1 (4.0 mmol) with the monomer 1 (1.0 mmol) and a monomer 7 shown below (3.0 mmol), the same method as the charge transport polymer 1 was used to prepare a charge transport polymer 5. The thus obtained charge transport polymer 5 had a number average molecular of 10,959 and a mass average molecular weight of 69,631.

### (Charge Transport Polymer 6)

With the exception of replacing the monomer 1 (4.0 mmol) with the monomer 1 (1.0 mmol) and a monomer 8 shown below (3.0 mmol), the same method as the charge transport polymer 1 was used to prepare a charge transport polymer 6. The thus obtained charge transport polymer 6 had a number average molecular of 14,587 and a mass average molecular weight of 68,111.

### (Charge Transport Polymer 7)

With the exception of replacing the monomer 1 (4.0 mmol) with the monomer 1 (1.0 mmol) and a monomer 9 shown below (3.0 mmol), the same method as the charge transport polymer 1 was used to prepare a charge transport polymer 7. The thus obtained charge transport polymer 7 had a number average molecular of 7,522 and a mass average molecular weight of 43,238.

### (Charge Transport Polymer 8)

With the exception of replacing the monomer 3 (2.0 mmol) with a monomer 10 shown below (2.0 mmol), the same method as the charge transport polymer 3 was used to prepare a charge transport polymer 8. The thus obtained charge transport polymer 8 had a number average molecular of 18,522 and a mass average molecular weight of 76,471.

### (Charge Transport Polymer 9)

With the exception of replacing the monomer 3 (2.0 mmol) with the monomer 10 shown below (2.0 mmol), the same method as the charge transport polymer 4 was used to prepare a charge transport polymer 9. The thus obtained charge transport polymer 9 had a number average molecular of 13,887 and a mass average molecular weight of 64,613.

### (Charge Transport Polymer 10)

With the exception of replacing the monomer 3 (2.0 mmol) with the monomer 10 shown below (2.0 mmol), the same method as the charge transport polymer 5 was used to prepare a charge transport polymer 9. The thus obtained charge transport polymer 10 had a number average molecular of 8,709 and a mass average molecular weight of 37,657.

### (Charge Transport Polymer 11)

With the exception of replacing the monomer 3 (2.0 mmol) with a monomer 11 shown below (2.0 mmol), the same method as the charge transport polymer 3 was used to prepare a charge transport polymer 11. The thus obtained charge transport polymer 11 had a number average molecular of 12,135 and a mass average molecular weight of 62,780.

### (Charge Transport Polymer 12)

With the exception of replacing the monomer 3 (2.0 mmol) with the monomer 11 shown below (2.0 mmol), the same method as the charge transport polymer 4 was used to prepare a charge transport polymer 12. The thus obtained charge transport polymer 12 had a number average molecular of 11,358 and a mass average molecular weight of 59,976.

### (Charge Transport Polymer 13)

With the exception of replacing the monomer 3 (2.0 mmol) with the monomer 11 shown below (2.0 mmol), the same method as the charge transport polymer 5 was used to prepare a charge transport polymer 13. The thus obtained charge transport polymer 13 had a number average molecular of 10,743 and a mass average molecular weight of 82,412.

Monomers 5 to 11 are shown below.

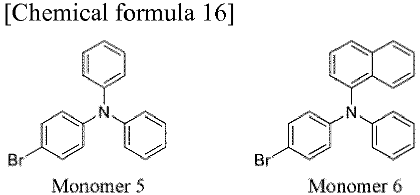

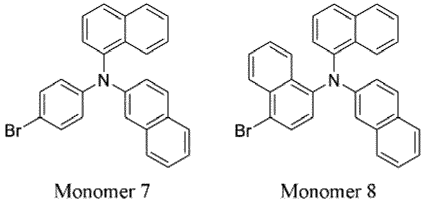

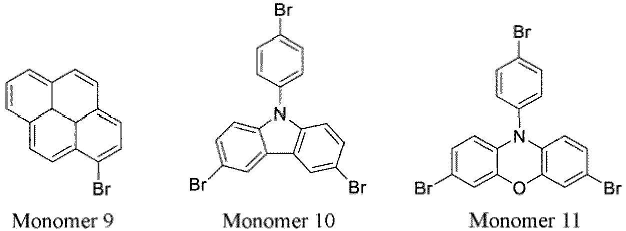

The monomers used in preparing each of the polymers are summarized below.

**[Table 1]**

| Charge transport polymer | Monomers used | | |
|---|---|---|---|
| | Structural unit L | Structural unit B | Structural unit T |
| 1 | Monomer 2 | Monomer 3 | Monomer 1 |
| 2 | Monomer 2 | Monomer 3 | Monomer 4 |
| 3 | Monomer 2 | Monomer 3 | Monomer 1, Monomer 5 |
| 4 | Monomer 2 | Monomer 3 | Monomer 1, Monomer 6 |
| 5 | Monomer 2 | Monomer 3 | Monomer 1, Monomer 7 |
| 6 | Monomer 2 | Monomer 3 | Monomer 1, Monomer 8 |
| 7 | Monomer 2 | Monomer 3 | Monomer 1, Monomer 9 |
| 8 | Monomer 2 | Monomer 10 | Monomer 1, Monomer 5 |
| 9 | Monomer 2 | Monomer 10 | Monomer 1, Monomer 6 |
| 10 | Monomer 2 | Monomer 10 | Monomer 1, Monomer 7 |
| 11 | Monomer 2 | Monomer 11 | Monomer 1, Monomer 5 |
| 12 | Monomer 2 | Monomer 11 | Monomer 1, Monomer 6 |
| 13 | Monomer 2 | Monomer 11 | Monomer 1, Monomer 7 |

The same compounds are sometimes labeled using different symbols across the Example A described above and the Examples B, C and D described below. For example, the monomer 1 used in the preparation examples of Example A is the same as a monomer T1a, the monomer 2 is the same as a monomer L1, and the monomer 3 is the same as a monomer B1 in the following Example B.

### <1-2> Evaluation of Charge Transport Polymers

The thermal weight reduction upon heating at 300°C for each of the charge transport polymers 1 and 3 to 13 is shown in Table 2. The thermal weight reduction was determined by using a TG-DTA measurement apparatus (DTG-60/60H, manufactured by Shimadzu Corporation) to measure the thermal weight reduction ratio when 10 mg of the polymer was heated in the air to 300°C under temperature increase conditions of 5°C/minute (with the same method also used in the following examples besides Example A). A smaller measured value means superior heat resistance. Although not shown in Table 2, the thermal weight reduction ratio for the charge transport polymer 2 was 3.0% by mass.

### <2-1> Production of Organic HOD Elements

### (Example 1)

Under a nitrogen atmosphere, an ink composition composed of the charge transport polymer 3 (10.0 mg) obtained by the charge transport polymer synthesis described above, an ionic compound 1 shown below (0.5 mg) and toluene (2.3 ml) was spin-coated at 3,000 min⁻¹ onto glass substrates on which ITO had been patterned with a width of 1.6 mm, and subsequently, the ink composition was cured by heating at 200°C for 30 minutes on a hotplate in the open atmosphere, thus a substrate on which a hole injection layer (100 nm) had been formed was heated at 200°C for 30 minutes in the open atmosphere, and then heating at 230°C for 30 minutes in a nitrogen atmosphere, thus producing a substrate on which a hole injection layer (100 nm) had been formed.

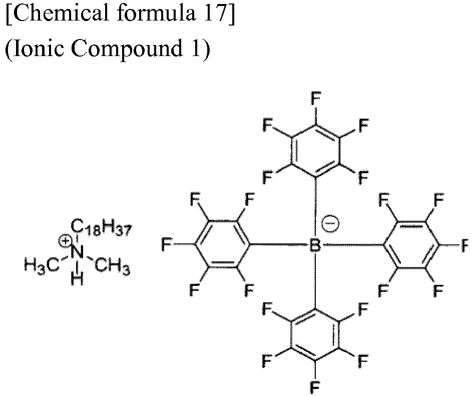

The substrates obtained above were each transferred to a vacuum deposition apparatus, α-NPD (20 nm) and Al (100 nm) were deposited sequentially on top of the above hole injection layer using deposition methods, and an encapsulation treatment was then performed to complete production of an organic HOD (hole-only device) element.

### (Examples 2 to 11, Comparative Example 1)

A series of ink compositions was prepared by changing the charge transport polymer 3 from the ink composition used for forming the hole injection layer of the organic EL element in Example 1 to each of the charge transport polymers shown below in Table 2. With the exception of using each of these ink compositions to form the hole injection layer, organic HOD elements of Examples 2 to 11 and Comparative Example 1 were produced in exactly the same manner as Example 1.

### <2-2> Evaluation of Organic HOD Elements

When a voltage was applied to the organic HOD elements obtained in Examples 1 to 11 and Comparative Example 1, current flow was observed in each case, confirming that the element had hole injection functionality. For each element, the drive voltage at a current density of 300 mA/cm was measured. The measurement results are shown in Table 2. In the tables below, including Table 2, the drive voltage (V1) represents the drive voltage after heating at 200°C for 30 minutes, and the drive voltage (V2) represents the drive voltage after heating at 200°C for 30 minutes and then heating at 230°C for a further 30 minutes. The increase in drive voltage is the value of drive voltage 2 (V) - drive voltage 1 (V). Measurements of the drive voltage were performed using a SourceMeter 2400 apparatus manufactured by Keithley Instruments, LLC, under conditions including a measurement temperature of 25°C (this also applies to measurements performed in the following Examples B to D).

### <3-1> Production of Organic EL Elements

### (Example 1)

Under a nitrogen atmosphere, an ink composition composed of the charge transport polymer 3 (10.0 mg) obtained by the charge transport polymer synthesis described above, the ionic compound 1 shown above (0.5 mg) and toluene (2.3 mL) was spin-coated at 3,000 min⁻¹ onto a glass substrate on which ITO had been patterned with a width of 1.6 mm, and the ink composition was then cured by heating at 200°C for 30 minutes, and then heating at 230°C for 30 minutes, thus forming a hole injection layer (30 nm).

Subsequently, an ink composition composed of the charge transport polymer 2 obtained above (20 mg) and toluene (2.3 mL) was spin-coated at 3,000 min⁻¹ onto the hole injection layer obtained in the above procedure, and the ink composition was then dried by heating on a hotplate at 180°C for 10 minutes, thus forming a hole transport layer (40 nm). The hole transport layer was able to be formed without dissolving the hole injection layer.

The thus obtained substrate was transferred into a vacuum deposition apparatus, layers of CBP:Ir(ppy)₃ (94:6, 30 nm), BAlq (10 nm), Alq₃ (30 nm), LiF (0.8 nm) and Al (100 nm) were deposited in that order using deposition methods on top of the hole transport layer, and an encapsulation treatment was then performed to complete production of an organic EL element.

### (Examples 2 to 11, Comparative Example 1)

A series of ink compositions was prepared by changing the charge transport polymer 3 from the ink composition used for forming the hole injection layer of the organic EL element in Example 1 to each of the charge transport polymers shown below in Table 2. With the exception of using each of these ink compositions to form the hole injection layer, organic EL elements of Examples 2 to 11 and Comparative Example 1 were produced in exactly the same manner as Example 1.

### <3-2> Evaluation of Organic EL Elements

When a voltage was applied to each of the organic EL elements obtained above, green light emission was confirmed in each case. For each element, the drive voltage and emission efficiency at a luminance of 5,000 cd/m², and the emission lifespan (luminance half-life) when the initial luminance was 5,000 cd/m² were measured. The measurement results are shown in Table 2.

**[Table 2]**

| | | Polymer evaluation | Evaluations of organic HOD elements | | | Evaluations of organic EL elements | | |
|---|---|---|---|---|---|---|---|---|
| Item | Charge transport polymer | Thermal weight reduction upon heating at 300°C (% by mass) | Drive voltage (V1) | Drive voltage (V2) | Increase in drive voltage (V2)-(V1) | Drive voltage (V) | Emission efficiency (cd/A) | Emission lifespan (h) |
| Example 1 | 3 | 4.1 | 2.8 | 3.1 | 0.3 | 7.5 | 17.3 | 178 |
| Example 2 | 4 | 3.1 | 3.2 | 3.5 | 0.3 | 7.7 | 18.8 | 225 |
| Example 3 | 5 | 2.5 | 2.6 | 3.1 | 0.5 | 8.2 | 18.5 | 212 |
| Example 4 | 6 | 2.0 | 3.0 | 3.6 | 0.6 | 8.3 | 18.6 | 209 |
| Example 5 | 7 | 2.5 | 3.2 | 3.9 | 0.7 | 7.5 | 17.8 | 190 |
| Example 6 | 8 | 3.0 | 3.4 | 4.0 | 0.6 | 7.9 | 19.5 | 178 |
| Example 7 | 9 | 3.0 | 4.0 | 4.6 | 0.6 | 7.9 | 19.5 | 176 |
| Example 8 | 10 | 3.0 | 5.0 | 5.8 | 0.8 | 8.0 | 17.8 | 169 |
| Example 9 | 11 | 3.1 | 4.0 | 4.8 | 0.8 | 8.4 | 18.1 | 193 |
| Example 10 | 12 | 3.0 | 4.0 | 4.8 | 0.8 | 8.2 | 18.8 | 200 |
| Example 11 | 13 | 2.9 | 4.5 | 5.3 | 0.8 | 8.4 | 18.0 | 190 |
| Comparative Example 1 | 1 | 5.9 | 3.5 | 7.0 | 3.5 | 8.2 | 16.8 | 168 |

As shown in Table 2, the organic HOD elements of Examples 1 to 11 exhibited a smaller increase in drive voltage after the additional heating at 230°C for 30 minutes than the element of Comparative Example 1, and exhibited results that indicated that a low drive voltage could be maintained. In other words, from the viewpoint of the constituent materials for the hole injection layer, it is evident that by using a charge transport polymer having a low thermal weight reduction and improved heat resistance as the charge transport material, results can be obtained that indicate favorable maintenance of the hole injection properties during high-temperature processes.

Further, as shown in Table 2, the organic EL elements of Examples 1 to 11 exhibited superior emission efficiency and had a longer emission lifespan than the element of Comparative Example 1. In other words, from the viewpoint of the constituent materials for the hole injection layer, it is evident that by using a charge transport polymer having a low thermal weight reduction as the charge transport material, high-temperature heating is possible, and results can be obtained that indicate improvements in the emission efficiency and the emission lifespan.

### [Example B: Examples 1B to 10B]

### <1-1> Preparation of Charge Transport Polymers

### (Preparation of Pd Catalyst)

A Pd catalyst was prepared in the same manner as that described for Example A.

### (Charge Transport Polymer 2B)

A three-neck round-bottom flask was charged with a monomer L1 shown below (5.0 mmol), a monomer B1 shown below (2.0 mmol), a monomer T1b shown below (4.0 mmol) and anisole (20 mL), and the prepared Pd catalyst solution (7.5 mL) was then added. After stirring for 30 minutes, a 10% aqueous solution of tetraethylammonium hydroxide (20 mL) was added. All of the solvents were deaerated by nitrogen bubbling for at least 30 minutes prior to use. The resulting mixture was heated and refluxed for 2 hours. All the operations up to this point were conducted under a stream of nitrogen.

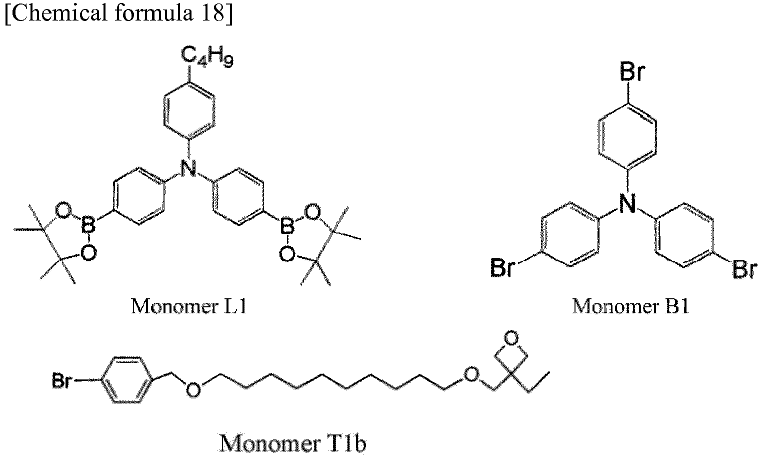

After completion of the reaction, the organic layer was washed with water and then poured into methanol-water (9:1). The resulting precipitate was collected by filtration under reduced pressure, and washed with methanol-water (9:1). The thus obtained precipitate was dissolved in toluene, and re-precipitated from methanol. The obtained precipitate was then collected by filtration under reduced pressure and dissolved in toluene, and a metal adsorbent ("Triphenylphosphine, polymer-bound on styrenedivinylbenzene copolymer", manufactured by Strem Chemicals Inc., 200 mg per 100 mg of the precipitate) was then added to the solution and stirred overnight.

Following completion of the stirring, the metal adsorbent and other insoluble matter were removed by filtration, and the filtrate was concentrated using a rotary evaporator. The concentrate was dissolved in toluene, and then re-precipitated from methanol-acetone (8:3). The thus produced precipitate was collected by filtration under reduced pressure and washed with methanol-acetone (8:3). The thus obtained precipitate was then dried under vacuum to obtain a charge transport polymer 2B.

The thus obtained charge transport polymer 2B had a number average molecular of 24,700 and a weight average molecular weight of 49,100. The charge transport polymer 2B had a structural unit L (derived from the monomer L1), a structural unit B (derived from the monomer B1) and a structural unit T1 (derived from the monomer T1b), and the proportions of those structural units were 45.5%, 18.2% and 36.3% respectively.

### (Charge Transport Polymer 3B)

A three-neck round-bottom flask was charged with the monomer L1 shown above (5.0 mmol), the monomer B1 shown above (2.0 mmol), a monomer T1c shown below (4.0 mmol) and anisole (20 mL), and the prepared Pd catalyst solution (7.5 mL) was then added. Thereafter, the same method as that described for the charge transport polymer 2B was used to prepare a charge transport polymer 3B.

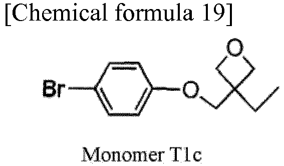

The thus obtained charge transport polymer 3B had a number average molecular of 15,100 and a weight average molecular weight of 58,200. The charge transport polymer 3B had a structural unit L (derived from the monomer L1), a structural unit B (derived from the monomer B1) and a structural unit T1 (derived from the monomer T1c), and the proportions of those structural units were 45.5%, 18.2% and 36.3% respectively.

### (Charge Transport Polymer 4B)

A three-neck round-bottom flask was charged with the monomer L1 shown above (5.0 mmol), the monomer B1 shown above (2.0 mmol), the monomer T1c shown above (1.0 mmol), a monomer T2a shown below (3.0 mmol) and anisole (20 mL), and the prepared Pd catalyst solution (7.5 mL) was then added. Thereafter, the same method as that described for the charge transport polymer 2B was used to prepare a charge transport polymer 4B.

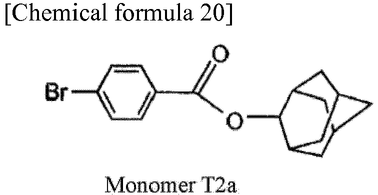

The thus obtained charge transport polymer 4B had a number average molecular of 15,700 and a weight average molecular weight of 56,400. The charge transport polymer 4B had a structural unit L (derived from the monomer L1), a structural unit B (derived from the monomer B1), a structural unit T1 (derived from the monomer T1c) and a structural unit T2 (derived from the monomer T2a), and the proportions of those structural units were 45.5%, 18.2%, 9.1% and 27.2% respectively.

### (Charge Transport Polymer 5B)

A three-neck round-bottom flask was charged with the monomer L1 shown above (5.0 mmol), the monomer B1 shown above (2.0 mmol), the monomer T1c shown above (1.2 mmol), the monomer T2a shown above (2.8 mmol) and anisole (20 mL), and the prepared Pd catalyst solution (7.5 mL) was then added. Thereafter, the same method as that described for the charge transport polymer 2B was used to prepare a charge transport polymer 5B.

The thus obtained charge transport polymer 5B had a number average molecular of 12,800 and a weight average molecular weight of 41,800. The charge transport polymer 5B had a structural unit L (derived from the monomer L1), a structural unit B (derived from the monomer B1), a structural unit T1 (derived from the monomer T1c) and a structural unit T2 (derived from the monomer T2a), and the proportions of those structural units were 45.5%, 18.2%, 10.9% and 25.4% respectively.

### (Charge Transport Polymer 6B)

A three-neck round-bottom flask was charged with the monomer L1 shown above (5.0 mmol), the monomer B1 shown above (2.0 mmol), the monomer T1c shown above (1.6 mmol), the monomer T2a shown above (2.4 mmol) and anisole (20 mL), and the prepared Pd catalyst solution (7.5 mL) was then added. Thereafter, the same method as that described for the charge transport polymer 2B was used to prepare a charge transport polymer 6B.

The thus obtained charge transport polymer 6B had a number average molecular of 12,600 and a weight average molecular weight of 41,000. The charge transport polymer 6B had a structural unit L (derived from the monomer L1), a structural unit B (derived from the monomer B1), a structural unit T1 (derived from the monomer T1c) and a structural unit T2 (derived from the monomer T2a), and the proportions of those structural units were 45.5%, 18.2%, 14.5% and 21.8% respectively.

### (Charge Transport Polymer 7B)

A three-neck round-bottom flask was charged with the monomer L1 shown above (5.0 mmol), the monomer B1 shown above (2.0 mmol), the monomer T1c shown above (2.0 mmol), the monomer T2a shown above (2.0 mmol) and anisole (20 mL), and the prepared Pd catalyst solution (7.5 mL) was then added. Thereafter, the same method as that described for the charge transport polymer 2B was used to prepare a charge transport polymer 7B.

The thus obtained charge transport polymer 7B had a number average molecular of 13,500 and a weight average molecular weight of 42,100. The charge transport polymer 7B had a structural unit L (derived from the monomer L1), a structural unit B (derived from the monomer B1), a structural unit T1 (derived from the monomer T1c) and a structural unit T2 (derived from the monomer T2a), and the proportions of those structural units were 45.5%, 18.2%, 18.15% and 18.15% respectively.

### (Charge Transport Polymer 8B)

A three-neck round-bottom flask was charged with the monomer L1 shown above (5.0 mmol), the monomer B1 shown above (2.0 mmol), the monomer T1c shown above (2.0 mmol), a monomer T2b shown below (2.0 mmol) and anisole (20 mL), and the prepared Pd catalyst solution (7.5 mL) was then added. Thereafter, the same method as that described for the charge transport polymer 2B was used to prepare a charge transport polymer 8B.

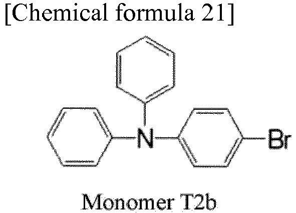

The thus obtained charge transport polymer 8B had a number average molecular of 13,000 and a weight average molecular weight of 45,100. The charge transport polymer 8B had a structural unit L (derived from the monomer L1), a structural unit B (derived from the monomer B1), a structural unit T1 (derived from the monomer T1c) and a structural unit T2 (derived from the monomer T2b), and the proportions of those structural units were 45.5%, 18.2%, 18.15% and 18.15% respectively.

### (Charge Transport Polymer 9B)

A three-neck round-bottom flask was charged with the monomer L1 shown above (5.0 mmol), the monomer B1 shown above (2.0 mmol), the monomer T1c shown above (1.0 mmol), the monomer T2b shown above (3.0 mmol) and anisole (20 mL), and the prepared Pd catalyst solution (7.5 mL) was then added. Thereafter, the same method as that described for the charge transport polymer 2B was used to prepare a charge transport polymer 9B.

The thus obtained charge transport polymer 9B had a number average molecular of 12,300 and a weight average molecular weight of 55,800. The charge transport polymer 9B had a structural unit L (derived from the monomer L1), a structural unit B (derived from the monomer B1), a structural unit T1 (derived from the monomer T1c) and a structural unit T2 (derived from the monomer T2b), and the proportions of those structural units were 45.5%, 18.2%, 9.1% and 27.2% respectively.

### (Charge Transport Polymer 10B)

A three-neck round-bottom flask was charged with the monomer L1 shown above (5.0 mmol), the monomer B1 shown above (2.0 mmol), the monomer T1c shown above (2.0 mmol), a monomer T2c shown below (2.0 mmol) and anisole (20 mL), and the prepared Pd catalyst solution (7.5 mL) was then added. Thereafter, the same method as that described for the charge transport polymer 2B was used to prepare a charge transport polymer 10B.

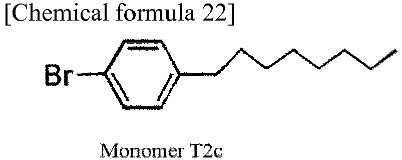

The thus obtained charge transport polymer 10B had a number average molecular of 15,700 and a weight average molecular weight of 45,100. The charge transport polymer 10B had a structural unit L (derived from the monomer L1), a structural unit B (derived from the monomer B1), a structural unit T1 (derived from the monomer T1c) and a structural unit T2 (derived from the monomer T2c), and the proportions of those structural units were 45.5%, 18.2%, 18.15% and 18.15% respectively.

### (Charge Transport Polymer 11B)

A three-neck round-bottom flask was charged with the monomer L1 shown above (5.0 mmol), the monomer B1 shown above (2.0 mmol), the monomer T1c shown above (1.0 mmol), the monomer T2c shown above (3.0 mmol) and anisole (20 mL), and the prepared Pd catalyst solution (7.5 mL) was then added. Thereafter, the same method as that described for the charge transport polymer 2B was used to prepare a charge transport polymer 11B.

The thus obtained charge transport polymer 11B had a number average molecular of 16,400 and a weight average molecular weight of 46,900. The charge transport polymer 11B had a structural unit L (derived from the monomer L1), a structural unit B (derived from the monomer B1), a structural unit T1 (derived from the monomer T1c) and a structural unit T2 (derived from the monomer T2c), and the proportions of those structural units were 45.5%, 18.2%, 9.1% and 27.2% respectively.

### (Charge Transport Polymer 12B)

A three-neck round-bottom flask was charged with a monomer L2 shown below (5.0 mmol), the monomer B1 shown above (2.0 mmol), the monomer T1c shown above (1.0 mmol), the monomer T2a shown above (3.0 mmol) and anisole (20 mL), and the prepared Pd catalyst solution (7.5 mL) was then added. Thereafter, the same method as that described for the charge transport polymer 2B was used to prepare a charge transport polymer 12B.

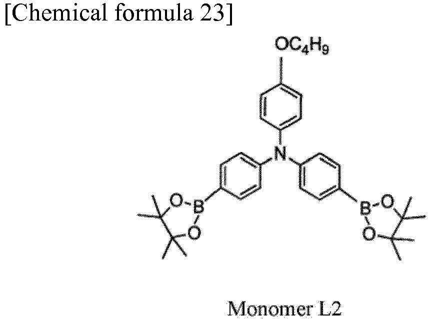

The thus obtained charge transport polymer 12B had a number average molecular of 18,900 and a weight average molecular weight of 49,100. The charge transport polymer 12B had a structural unit L (derived from the monomer L2), a structural unit B (derived from the monomer B1), a structural unit T1 (derived from the monomer T1c) and a structural unit T2 (derived from the monomer T2a), and the proportions of those structural units were 45.5%, 18.2%, 9.1% and 27.2% respectively.

The monomers used in the preparation of the charge transport polymers 2B to 12B are shown below in Table 3. In the table, monomers labeled with (*) have a structure represented by formula (I).

**[Table 3]**

| Charge transport polymer | Monomers used | | |
|---|---|---|---|
| | Structural unit L | Structural unit B | Structural unit T |
| 2B | L1 | B1 | T1b |
| 3B | L1 | B1 | T1c (*) |
| 4B | L1 | B1 | T1c (*) + T2f |
| 5B | L1 | B1 | T1c (*) + T2f |
| 6B | L1 | B1 | T1c (*) + T2f |
| 7B | L1 | B1 | T1c (*) + T2f |
| 8B | L1 | B1 | T1c (*) + T2a |
| 9B | L1 | B1 | T1c (*) + T2a |
| 10B | L1 | B1 | T1c (*) + T2g |
| 11B | L1 | B1 | T1c (*) + T2g |
| 12B | L2 | B1 | T1c (*) + T2f |

### <1-2> Evaluation of Charge Transport Polymers

The thermal weight reduction upon heating at 300°C for each of the charge transport polymers 2B to 12B is shown in Table 4.

### <2-1> Production of Organic HOD Elements

### (Example 1B)

An ink composition was prepared in the open atmosphere by mixing the charge transport polymer 3B prepared above (10.0 mg), a polymerization initiator 1 shown below (0.5 mg) and toluene (2.3 mL). This ink composition was spin-coated at a rotational rate of 3,000 min⁻¹ onto a glass substrate on which ITO had been patterned with a width of 1.6 mm, and the ink composition was then cured by heating at 200°C for 30 minutes on a hotplate, thus forming a hole injection layer (100 nm).

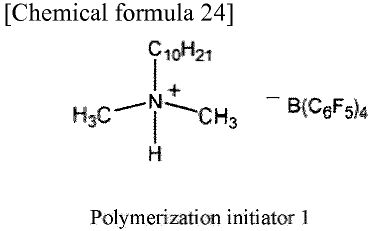

The glass substrate obtained above was transferred to a vacuum deposition apparatus, α-NPD (20 nm) and Al (100 nm) were deposited sequentially on top of the above hole injection layer using deposition methods, and an encapsulation treatment was then performed to complete production of an organic HOD element (I).

Using the same procedure as that used in the production of the organic HOD element 1, the ink composition was spin-coated at a rotational rate of 3,000 min⁻¹ onto a glass substrate on which ITO had been patterned with a width of 1.6 mm, and the ink composition was heated at 200°C for 30 minutes on a hotplate. With the exception of then performing additional heating at 230°C for 30 minutes under a nitrogen atmosphere to form the hole injection layer, an organic HOD element (II) was produced in the same manner as the organic HOD element (I).

### (Examples 2B to 10B, Comparative Example 1B)

With the exception of replacing the charge transport polymer 3B with a charge transport polymer shown below in Table 4 in the formation step for the hole injection layer in the organic HOD element of Example 1B, organic HOD elements of each of the above examples and the comparative example were produced in the same manner as Example 1B.

### <2-2> Evaluation of HOD Elements (Hole Injection Layers)

A voltage was applied to the organic HOD element produced in each of the above Examples B and the Comparative Example B. The results indicated current flow in each case, confirming that each of the elements had hole injection functionality. Further, the drive voltage was measured for each element. The drive voltage for the organic HOD element (I) was labeled (V1), and the drive voltage for the organic HOD element (II) was labeled (V2). The measurement results are shown in Table 4.

### <3-1> Production of Organic EL Elements

Organic EL elements were produced which contained hole injection layers formed using the charge transport polymers prepared above, and the performance of the elements was evaluated.

### (Example 1B)

An ink composition was prepared in the open atmosphere by mixing the charge transport polymer 3B (10.0 mg), the polymerization initiator 1 shown above (0.5 mg) and toluene (2.3 mL). This ink composition was spin-coated at a rotational rate of 3,000 min⁻¹ onto a glass substrate on which ITO had been patterned with a width of 1.6 mm, and the ink composition was then cured by heating at 200°C for 10 minutes on a hotplate. Additional heating was then performed at 230°C for 30 minutes under a nitrogen atmosphere, thus forming a hole injection layer (30 nm).

The glass substrate having the above hole injection layer was transferred into a vacuum deposition apparatus, and layers of α-NPD (40 nm), CBP:Ir(ppy)₃ (94:6, 30 nm), BAlq (10 nm), TPBi (30 nm), LiF (0.8 nm) and Al (100 nm) were deposited in that order using deposition methods on top of the hole transport layer. An encapsulation treatment was then performed to complete production of an organic EL element.

### (Examples 2B to 10B)

With the exception of replacing the charge transport polymer 3B with a charge transport polymer shown below in Table 4 in the formation step for the hole injection layer in the organic EL element of Example 1B, organic EL elements were produced in the same manner as Example 1B.

### <3-2> Evaluation of Organic EL Elements

When a voltage was applied to each of the organic EL elements obtained in Examples 1B to 10B, green light emission was confirmed in each case. For each element, the drive voltage and emission efficiency at a luminance of 5,000 cd/m², and the emission lifespan (luminance half-life) when the initial luminance was 5,000 cd/m² were measured. The measurement results are shown in Table 4.

**[Table 4]**

| | | Polymer evaluation | Evaluations of organic HOD elements | | | Evaluations of organic EL elements | | |
|---|---|---|---|---|---|---|---|---|
| Item | Charge transport polymer | Thermal weight reduction upon heating at 300°C (% by mass) | Drive voltage (V1) | Drive voltage (V2) | Increase in drive voltage (V2)-(V1) | Drive voltage (V) | Emission efficiency (cd/A) | Emission lifespan (h) |
| Example 1B | 3B | 3.1 | 3.8 | 4.2 | 0.4 | 8.2 | 30 | 303 |
| Example 2B | 4B | 0.8 | 3.5 | 3.5 | 0.0 | 7.6 | 32.9 | 318 |
| Example 3B | 5B | 1.0 | 2.8 | 2.8 | 0.0 | 8.2 | 33.6 | 330 |
| Example 4B | 6B | 1.0 | 3.0 | 2.9 | 0.1 | 7.2 | 33.9 | 402 |
| Example 5B | 7B | 1.0 | 3.0 | 3.0 | 0.0 | 7.9 | 30.0 | 363 |
| Example 6B | 8B | 1.4 | 2.8 | 3.2 | 0.4 | 7.9 | 30.0 | 369 |
| Example 7B | 9B | 0.8 | 3.0 | 3.1 | 0.1 | 8.0 | 30.3 | 330 |
| Example 8B | 10B | 2.4 | 2.6 | 3.2 | 0.5 | 7.9 | 30.0 | 315 |
| Example 9B | 11B | 2.3 | 2.8 | 2.9 | 0.1 | 8.0 | 30.6 | 303 |
| Example 10 | 12B | 0.4 | 2.8 | 3.8 | 1.0 | 7.8 | 29.7 | 303 |
| Comparative Example 1B | 2B | 12.0 | 3.5 | >10.0 | >6.5 | 9.2 | 28.5 | 258 |

As shown in Table 4 above, the organic HOD elements of Examples 1B to 10B exhibited a smaller increase in drive voltage than the element of Comparative Example 1B. In other words, from the viewpoint of the constituent materials for the hole injection layer, it is evident that by using an organic electronic material containing a charge transport polymer having a low thermal weight reduction (and having excellent heat resistance), any increase in the drive voltage following high-temperature heating can be suppressed. Based on these results, it is clear that by using the organic electronic material that represents an embodiment of the present invention, thermal degradation of the organic layer can be suppressed.

Further, the organic EL elements of Examples 1B to 10B have hole injection layers obtained by application of a high-temperature baking treatment. In each case, excellent results were obtained for the drive voltage, the emission efficiency and the emission lifespan. In other words, it is evident that by using a charge transport polymer having excellent heat resistance as the hole injection layer material, thermal degradation can be suppressed, and favorable hole injection characteristics can be maintained.

### [Example C: Examples 1C to 7C]

### <1> Preparation of Raw Material Monomers

### (Preparation of Compound A)

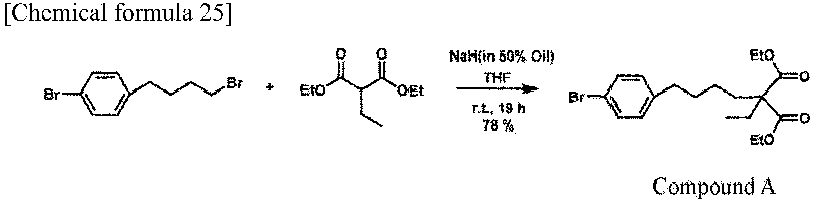

A round-bottom flask was charged with diethyl 2-ethylmalonate (27 mmol) and anhydrous tetrahydrofuran (20 ml), and after cooling to 0°C and stirring for 15 minutes, NaH (in 50% oil) was added gradually. Subsequently, the temperature was returned to room temperature, and after stirring for 2.5 hours, a solution prepared by dissolving 1-bromo-4-(4-bromobutyl)benzene (25 mmol) in tetrahydrofuran (10 ml) was added dropwise to the flask, and the resulting mixture was then stirred at room temperature for 19 hours. Subsequently, following quenching with water, the reaction mixture was extracted into ethyl acetate, and then dried over anhydrous magnesium sulfate. The solvent was removed using an evaporator, and the thus obtained crude product was purified by silica gel column chromatography (filler: Wakogel (a registered trademark) C-300HG, mobile phase: n-hexane:ethyl acetate = 20:1), thus obtaining 7.8 g of a compound A as a colorless oily substance (yield: 78%).

¹H-NMR measurement results for the compound A were as follows.

¹H-NMR (300 MHz, CDCl₃, δ ppm): 0.86 (t, J=7.5 Hz, 3H), 1.76 (t, J=7.5 Hz, 2H), 3.57 (s, 2H), 4.39 (d, J=5.7 Hz, 2H), 4.45 (d, J=5.7Hz, 2H), 4.51 (s, 2H), 7.22 (d, J=8.4 Hz, 2H), 7.47 (d, J=8.4 Hz, 2H).

### (Preparation of Compound B)

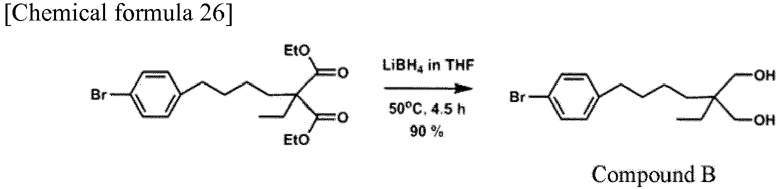

A round-bottom flask was charged with the compound A prepared above (19.5 mmol), a THF solution of LiBH₄ (43 ml) was added dropwise to the flask, and the resulting mixture was stirred at 50°C for 4.5 hours. Following completion of the reaction, the reaction mixture was quenched with isopropanol, methanol and water while being cooled, and was then extracted into ethyl acetate and dried over anhydrous magnesium sulfate. The solvent was then removed using an evaporator, thus obtaining 5.56 g of a compound B as a white solid (yield: 90%).

¹H-NMR measurement results for the compound B were as follows.

¹H-NMR (300 MHz, CDCl₃, δ ppm): 0.86 (t, J=7.5 Hz, 3H), 1.76 (t, J=7.5 Hz, 2H), 3.57 (s, 2H), 4.39 (d, J=5.7 Hz, 2H), 4.45 (d, J=5.7Hz, 2H), 4.51 (s, 2H), 7.22 (d, J=8.4 Hz, 2H), 7.47 (d, J=8.4 Hz, 2H).

### (Preparation of Monomer C1)

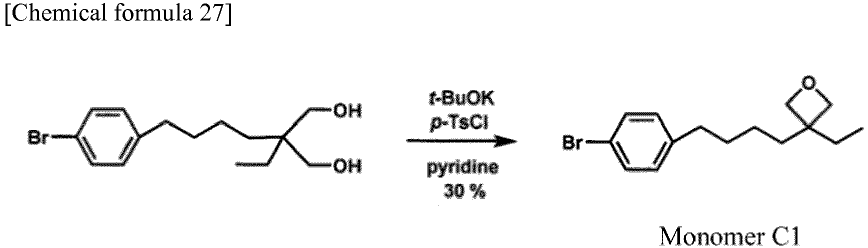

A round-bottom flask was charged with the compound B prepared above (17.6 mmol), pyridine (200 ml) and potassium t-butoxide (19.4 mmol), and the resulting mixture was stirred at room temperature for one hour. Subsequently, p-toluenesulfonyl chloride (21.2 mmol) was added, and stirring was continued at room temperature for 12 hours. Additional potassium t-butoxide (26.5 mmol) was then added, and the mixture was heated to 100°C and stirred for 6 hours. Following completion of the reaction, the reaction mixture was quenched with water, extracted into ethyl acetate, and then dried over anhydrous magnesium sulfate. The solvent was then removed using an evaporator, and the thus obtained crude product was purified by silica gel column chromatography (filler: Wakogel (a registered trademark) C-300HG, mobile phase: n-hexane:ethyl acetate = 8:1), thus obtaining a monomer C1 (1.5 g) as a colorless oily substance (yield: 30%).

¹H-NMR measurement results for the monomer C1 were as follows.

¹H-NMR (300 MHz, CDCl₃, δ ppm): 0.86 (t, J=7.5 Hz, 3H), 1.76 (t, J=7.5 Hz, 2H), 3.57 (s, 2H), 4.39 (d, J=5.7 Hz, 2H), 4.45 (d, J=5.7Hz, 2H), 4.51 (s, 2H), 7.22 (d, J=8.4 Hz, 2H), 7.47 (d, J=8.4 Hz, 2H).

### <2-1> Synthesis of Hole Transport Polymers

Hole transport polymers 1C to 4C and 6C to 8C were synthesized and then evaluated in the manner described below as Examples 1C to 7C.

### (Preparation of Pd Catalyst)

A Pd catalyst was prepared in the same manner as that described above for Example A.

### (Raw Material Monomers for Hole Transport Polymers C)

The raw material monomers used in the synthesis of the hole transport polymers described below were as follows.

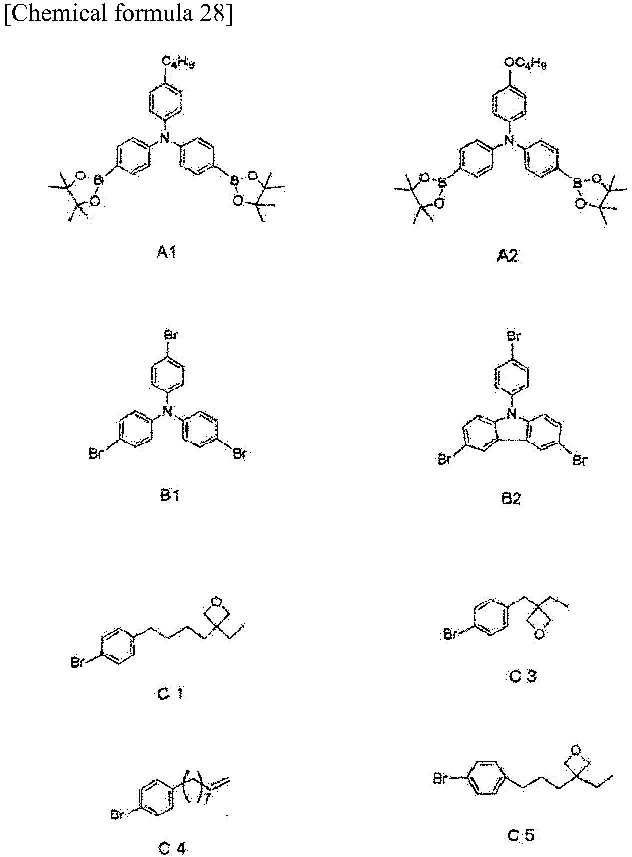

### (Hole Transport Polymer 1C)

A three-neck round-bottom flask was charged with the monomer A1 (5.0 mmol), the monomer B1 (2.0 mmol), the monomer C1 (4.0 mmol), methyl tri-n-octyl ammonium chloride ("Aliquat 336" manufactured by Alfa Aesar Ltd.) (0.03 g), potassium hydroxide (1.12 g), pure water (5.54 mL) and toluene (50 mL), and the prepared Pd catalyst toluene solution (3.0 mL) was then added. All of the solvents were deaerated by nitrogen bubbling for at least 30 minutes prior to use. The resulting mixture was heated and refluxed for 2 hours. All the operations up to this point were conducted under a stream of nitrogen.

After completion of the reaction, the organic layer was washed with water and then poured into methanol-water (9:1). The resulting precipitate was collected by filtration under reduced pressure, and washed with methanol-water (9:1). The thus obtained precipitate was dissolved in toluene, and re-precipitated from methanol. The obtained precipitate was then collected by filtration under reduced pressure and dissolved in toluene, and a metal adsorbent ("Triphenylphosphine, polymer-bound on styrenedivinylbenzene copolymer", manufactured by Strem Chemicals Inc., 200 mg per 100 mg of the precipitate) was then added to the solution and stirred at 80°C for 2 hours. Following completion of the stirring, the metal adsorbent and other insoluble matter were removed by filtration, and the filtrate was re-precipitated from methanol.

The thus produced precipitate was collected by filtration under reduced pressure, and washed with methanol. The thus obtained precipitate was then dried under vacuum, yielding a hole injection compound 1C. The molecular weight was measured by GPC (relative to polystyrene standards) using THF as the eluent. The thus obtained hole transport polymer 1C had a number average molecular of 13,600 and a weight average molecular weight of 49,200.

### (Hole Transport Polymer 2C)

A three-neck round-bottom flask was charged with the monomer A1 shown above (5.0 mmol), the monomer B2 shown above (2.0 mmol), the monomer C1 shown above (4.0 mmol) and toluene (20 mL), and the prepared Pd catalyst solution (7.5 mL) was then added. Thereafter, a hole transport polymer 2C was synthesized in the same manner as the synthesis of the hole transport polymer 1C. The thus obtained hole transport polymer 2C had a number average molecular of 14,700 and a weight average molecular weight of 50,100.

### (Hole Transport Polymer 3C)

A three-neck round-bottom flask was charged with the monomer A2 shown above (5.0 mmol), the monomer B1 shown above (2.0 mmol), the monomer C1 shown above (4.0 mmol) and toluene (20 mL), and the prepared Pd catalyst solution (7.5 mL) was then added. Thereafter, a hole transport polymer 3C was synthesized in the same manner as the synthesis of the hole transport polymer 1C. The thus obtained hole transport polymer 3C had a number average molecular of 15,700 and a weight average molecular weight of 46,400.

### (Hole Transport Polymer 4C)

A three-neck round-bottom flask was charged with the monomer A2 shown above (5.0 mmol), the monomer B2 shown above (2.0 mmol), the monomer C1 shown above (4.0 mmol) and toluene (20 mL), and the prepared Pd catalyst solution (7.5 mL) was then added. Thereafter, a hole transport polymer 4C was synthesized in the same manner as the synthesis of the hole transport polymer 1C. The thus obtained hole transport polymer 4C had a number average molecular of 12,300 and a weight average molecular weight of 47,000.

### (Hole Transport Polymer 6C)

A three-neck round-bottom flask was charged with the monomer A1 shown above (5.0 mmol), the monomer B1 shown above (2.0 mmol), the monomer C3 shown above (4.0 mmol) and toluene (20 mL), and the prepared Pd catalyst solution (7.5 mL) was then added. Thereafter, a hole transport polymer 5C was synthesized in the same manner as the synthesis of the hole transport polymer 1C. The thus obtained hole transport polymer 6C had a number average molecular of 15,300 and a weight average molecular weight of 49,800.

### (Hole Transport Polymer 7C)

A three-neck round-bottom flask was charged with the monomer A1 shown above (5.0 mmol), the monomer B1 shown above (2.0 mmol), the monomer C4 shown above (4.0 mmol) and toluene (20 mL), and the prepared Pd catalyst solution (7.5 mL) was then added. Thereafter, a hole transport polymer 6C was synthesized in the same manner as the synthesis of the hole transport polymer 1C. The thus obtained hole transport polymer 7C had a number average molecular of 18,900 and a weight average molecular weight of 49,100.

### (Hole Transport Polymer 8C)

A three-neck round-bottom flask was charged with the monomer A1 shown above (5.0 mmol), the monomer B1 shown above (2.0 mmol), the monomer C5 shown above (4.0 mmol) and toluene (20 mL), and the prepared Pd catalyst solution (7.5 mL) was then added. Thereafter, a hole transport polymer 7C was synthesized in the same manner as the synthesis of the hole transport polymer 1C. The thus obtained hole transport polymer 8C had a number average molecular of 17,400 and a weight average molecular weight of 42,300.

The monomers used in synthesizing the hole transport polymers 1C to 4C and 6C to 8C are summarized below in Table 5.

**[Table 5]**

| Charge transport polymer | Monomers used | | |
|---|---|---|---|
| | Structural unit L | Structural unit B | Structural unit T |
| 1C | Monomer A1 | Monomer B1 | Monomer C1 |
| 2C | Monomer A1 | Monomer B2 | Monomer C1 |
| 3C | Monomer A2 | Monomer B1 | Monomer C1 |
| 4C | Monomer A2 | Monomer B2 | Monomer C1 |
| 6C | Monomer A1 | Monomer B1 | Monomer C3 |
| 7C | Monomer A1 | Monomer B1 | Monomer C4 |
| 8C | Monomer A1 | Monomer B1 | Monomer C5 |

### <2-2> Evaluation of Hole Transport Polymers

Various characteristics of the hole transport polymers 1C to 4C and 6C to 8C synthesized above were evaluated in the following manner.

### (Heat Resistance)

The thermal weight reduction values for the hole transport polymers 1C to 4C and 6C to 8C upon heating at 300°C in the open atmosphere are shown in Table 6.

Based on the results shown in Table 6, it is evident that charge transport polymers having the specific structural region represented by the above formula (II) exhibit a small thermal weight reduction ratio upon heating at 300°C. Based on the above results, it is evident that by using the charge transport polymer (2) having the specific structural region represented by the above formula (II), an organic electronic material having excellent heat resistance can be provided.

### (Solubility)

The solubility of the hole transport polymers in toluene was investigated in the following manner.

A 10 mg sample of each of the hole transport polymers 1C to 4C and 6C to 8C was weighed into a sample tube, and 1.145 mL of toluene (specific gravity: 0.864 to 0.868 g/mL (20°C)) was added. Next, the hole transport polymer and the toluene were stirred at 25°C using a mixing rotor (50 rpm) while the mixture was observed visually, and the time required for the hole transport polymer to dissolve and form a transparent solution (the polymer dissolution time) was measured. The dissolution time measurement results are shown in Table 6.

As is evident from the results shown in Table 6, when a hole transport polymer was used in which the alkylene chain linking the polymerizable functional group had 3 or more carbon atoms, superior solubility could be easily achieved. Further, based on a comparison of the hole transport polymers 1C to 4C, it is evident that, compared with embodiments containing a triphenylamine structure and a carbazole structure within the main backbone of the hole transport polymer, embodiments containing only a triphenylamine structure tended to exhibit superior solubility.

### <3-1> Production of Organic HOD Elements

Using organic electronic materials (ink compositions) containing the previously synthesized hole transport polymers 1C to 4C and 6C to 8C, organic HOD elements were produced in the following manner, and the conductivity of those elements was then evaluated.

### (Example 1C)

An ink composition was prepared in the open atmosphere by mixing the hole transport polymer 1C (10.0 mg), the same polymerization initiator 1 as that used in Example B above (0.5 mg) and toluene (2.3 mL). This ink composition was spin-coated at a rotational rate of 3,000 min⁻¹ onto a glass substrate on which ITO had been patterned with a width of 1.6 mm, and the ink composition was then cured by heating at 200°C for 30 minutes on a hotplate, thus forming an organic layer (hole injection layer) (100 nm).

The glass substrate on which the above organic layer had been formed was transferred to a vacuum deposition apparatus, α-NPD (20 nm) and Al (100 nm) were deposited sequentially on top of the above organic layer using deposition methods, and an encapsulation treatment was then performed to complete production of an organic HOD element (I).

Using the same procedure as that used in the production of the organic HOD element (I), the ink composition was spin-coated at a rotational rate of 3,000 min⁻¹ onto a glass substrate on which ITO had been patterned with a width of 1.6 mm, and the ink composition was heated at 200°C for 30 minutes on a hotplate. With the exception of then performing additional heating at 230°C for 30 minutes under a nitrogen atmosphere to form the organic layer (hole injection layer), an organic HOD element (II) was produced in the same manner as the organic HOD element (I).

### (Examples 2C to 7C)

With the exception of replacing the hole transport polymer 1C with a hole transport polymer shown in Table 6 in the formation step for the organic layer (hole injection layer) in the organic HOD element of Example 1C, an organic HOD element (I) and organic HOD element (II) of each of Examples 2C to 7C were produced in the same manner as Example 1C.

### <3-2> Evaluation of HOD Elements

When a voltage was applied to the organic HOD elements (I) and (II) produced in each of the above examples, current flow was observed in each case, confirming that the organic layer had hole injection functionality. Further, the drive voltage was measured for the organic HOD elements (I) and (II) at a current density of 300 mA/cm (wherein the drive voltage for the organic HOD element (I) was labeled (V1), and the drive voltage for the organic HOD element (II) was labeled (V2)). The measurement results are shown in Table 6.

### <4-1> Production of Organic EL Elements

Using each of the charge transport polymers shown in Table 6, organic EL elements of Examples 1C to 7C were produced in the same manner as Example B described above.

### <4-2> Evaluation of Organic EL Elements

For each organic EL element produced above, the drive voltage and emission efficiency at a luminance of 5,000 cd/m², and the emission lifespan (luminance half-life) when the initial luminance was 5,000 cd/m² were measured. The measurement results are shown in Table 6.

**[Table 6]**

| | | Polymer evaluation | | Evaluations of organic HOD elements | | | Evaluations of organic EL elements | | |
|---|---|---|---|---|---|---|---|---|---|
| Item | Charge transport polymer | Thermal weight reduction upon heating at 300°C (% by mass) | Dissolution time | Drive voltage (V1) | Drive voltage (V2) | Increase in drive voltage (V2)-(V1) | Drive voltage (V) | Emission efficiency (cd/A) | Emission lifespan (h) |
| Example 1C | 1C | 3.0 | 6 minutes | 3.0 | 3.6 | 0.6 | 8.1 | 17.3 | 205 |
| Example 2C | 2C | 1.0 | 7 minutes | 2.9 | 3.0 | 0.1 | 8.2 | 17.0 | 203 |
| Example 3C | 3C | 1.2 | 8 minutes | 4.5 | 5.5 | 1.0 | 8.1 | 17.0 | 194 |
| Example 4C | 4C | 0.8 | 9 minutes | 4.0 | 4.2 | 0.2 | 8.2 | 16.8 | 192 |
| Example 5C | 6C | 3.0 | 14 minutes | 3.0 | 3.2 | 0.2 | 7.8 | 17.1 | 200 |
| Example 6C | 7C | 0.5 | 6 minutes | 4.0 | 4.8 | 0.8 | - | - | - |
| Example 7C | 8C | 2.5 | 7 minutes | 3.0 | 3.6 | 0.6 | 8.0 | 17.6 | 202 |

The hole transport polymers of Examples 1C to 7C are examples of the charge transport compound (2) having the specific structural region represented by the above formula (II). As is evident from Table 6, it is clear that the hole transport polymers of Examples 1C to 7C all have excellent heat resistance. Further, it is also evident that when organic electronic materials are formed using these hole transport polymers of excellent heat resistance, excellent conductivity is obtained. Moreover, based on the results for Examples 1C to 7C, it is evident that, in the specific structural region represented by the above formula (II), when the alkylene chain linking the polymerizable functional group has 3 or more carbon atoms, an improvement in the solubility can be achieved during ink preparation.

As described above, from the viewpoint of the constituent materials for the hole injection layer, it is evident that by forming an organic electronic material containing the hole transport polymer (2) having the specific structural region represented by the above formula (II), the heat resistance of the material and the conductivity of an organic layer formed from the material can be improved. Moreover, it is evident that by ensuring that the alkylene chain linking the polymerizable functional group has 3 or more carbon atoms, the solubility during ink preparation can be improved. Furthermore, in the organic EL elements of these examples, excellent results were obtained for the drive voltage, the emission efficiency and the emission lifespan.

### [Example D: Examples 1D and 2D]

### <1-1> Preparation of Charge Transport Polymers

A Pd catalyst solution was prepared in the following manner. All the solvents used in the catalyst preparation were deaerated by nitrogen bubbling for at least 30 minutes.

### (Pd Catalyst 3)

In a glove box under a nitrogen atmosphere and at room temperature, tris(dibenzylideneacetone)dipalladium (73.2 mg, 80 µmol) was weighed into a sample tube, anisole (15 mL) was added, and the resulting mixture was agitated for 30 minutes. In a similar manner, tris(t-butyl)phosphine (129.6 mg, 640 µmol) was weighed into a sample tube, anisole (5 mL) was added, and the resulting mixture was agitated for 5 minutes. The two solutions were then mixed together and stirred for 30 minutes at room temperature to obtain a catalyst.

Charge transport polymers were prepared in the following manner.

### (Charge Transport Polymer 1D)

A three-neck round-bottom flask was charged with a monomer A shown below (5.0 mmol), a monomer B shown below (2.0 mmol), a monomer C1 shown below (4.0 mmol) and anisole (20 mL), and the prepared solution of the Pd catalyst 3 (7.5 ml) was then added and stirred. After stirring for 30 minutes, a 10% aqueous solution of tetraethylammonium hydroxide (20 mL) was added. All of the raw materials were deaerated by nitrogen bubbling for at least 30 minutes prior to use. The resulting mixture was heated and refluxed for 2 hours. All the operations up to this point were conducted under a stream of nitrogen.

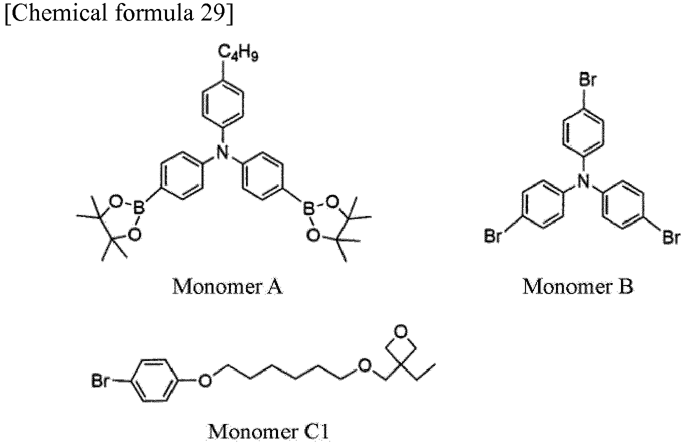

After completion of the reaction, the organic layer was washed with water and then poured into methanol-water (9:1) and re-precipitated. The resulting precipitate was collected by filtration under reduced pressure, and washed with methanol-water (9:1). The thus obtained precipitate was dissolved in toluene, and re-precipitated from methanol. The obtained precipitate was then collected by filtration under reduced pressure and dissolved in toluene, and a metal adsorbent (20 wt% relative to the total weight of precipitate) was then added to the solution and stirred overnight. Following completion of the stirring, the metal adsorbent and other insoluble matter were removed by filtration, and the filtrate was concentrated using a rotary evaporator. The concentrate was dissolved in toluene, and then re-precipitated from methanol-acetone (8:3). The thus produced precipitate was collected by filtration under reduced pressure and washed with methanol-acetone (8:3). The thus obtained precipitate was then dried under vacuum to obtain a charge transport polymer 1D. The thus obtained charge transport polymer 1D had a number average molecular weight of 16,200 and a weight average molecular weight of 48,300.

### (Charge Transport Polymer 3D)

A three-neck round-bottom flask was charged with the monomer A (5.0 mmol), the monomer B shown above (2.0 mmol), a monomer C3 shown below (4.0 mmol) and anisole (20 mL), and the prepared solution of the Pd catalyst 3 (7.5 ml) was then added. Thereafter, the same method as that described for the charge transport polymer 1D was used to prepare a charge transport polymer 3D. The thus obtained charge transport polymer 3D had a number average molecular of 14,700 and a weight average molecular weight of 42,000.

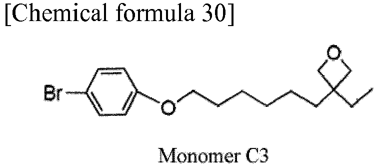

The monomers used in synthesizing the hole transport polymers 1D and 3D are summarized below in Table 7.

**[Table 7]**

| Charge transport polymer | Monomers used | | |
|---|---|---|---|
| | Structural unit L | Structural unit B | Structural unit T |
| 1D | Monomer A | Monomer B | Monomer C1 |
| 3D | Monomer A | Monomer B | Monomer C3 |

### <1-2> Evaluation of Charge Transport Polymers

### (Examples 1D and 2D)

The charge transport polymers 1D and 3D prepared above were evaluated for solubility and heat resistance (thermal weight reduction ratio) in the following manner.

### (Solubility)

The charge transport polymer 1D (8.8 mg) was weighed into a 6 mL screw-top vial, and toluene (1 mL) was added. A stirring bar (10 × ø4 mm) was inserted, and the mixture was stirred at 600 rpm at room temperature.

The dissolution time required from the start of stirring until the polymer completely dissolved was measured. The dissolution time means the time required, based on visual observation of the solution, for the solution to become transparent.

### <Heat Resistance>

In the same manner as that described above, for each of the charge transport polymers 1D and 3D (10 mg), the thermal weight reduction (% by mass) upon heating the polymer to 300°C in the air under temperature increase conditions of 5°C/minute was measured.

As shown in Table 8, for the charge transport polymers 1D and 3D which had at least one of the specific structural regions represented by formulas (III-1), (III-2) and (III-3), excellent results were obtained for both the solubility and the heat resistance.

### <2-1> Production of Organic HOD Elements

### (Example 1D)

An ink composition was prepared in the open atmosphere by mixing the previously prepared hole transport polymer 1D (10.0 mg), the polymerization initiator 1 described above (0.5 mg) and toluene (2.3 mL). This ink composition was spin-coated at a rotational rate of 3,000 min⁻¹ onto a glass substrate on which ITO had been patterned with a width of 1.6 mm, and the ink composition was then cured by heating at 200°C for 30 minutes on a hotplate, thus forming a hole injection layer (100 nm).

The glass substrate obtained above was transferred to a vacuum deposition apparatus, α-NPD (20 nm) and Al (100 nm) were deposited sequentially on top of the hole injection layer using deposition methods, and an encapsulation treatment was then performed to complete production of an organic HOD element (I).

Using the same procedure as that used in the production of the organic HOD element (I), the ink composition was spin-coated at a rotational rate of 3,000 min⁻¹ onto a glass substrate on which ITO had been patterned with a width of 1.6 mm, and the ink composition was heated at 200°C for 30 minutes on a hotplate. Additional heating was then performed at 230°C for 30 minutes under a nitrogen atmosphere to form a hole injection layer. Following formation of the hole injection layer in this manner, an organic HOD element (II) was produced in exactly the same manner as the production of the organic HOD element (I).

### (Example 2D)

With the exception of replacing the charge transport polymer 1D with the charge transport polymer 3D in the formation step for the hole injection layer in the organic HOD element of Example ID, organic HOD elements (I) and (II) were produced in the same manner as Example 1D.

### <2-2> Evaluation of HOD Elements

A voltage was applied to the organic HOD elements (I) and (II) produced in Examples 1D and 2D. From the results, it was evident that current flow occurred in each case, confirming that the element had hole injection functionality.

Further, the drive voltage was measured for the each of the elements at a current density of 300 mA/cm. The drive voltage for the organic HOD element (I) is shown as (V1), and the drive voltage for the organic HOD element (II) is shown as (V2).

### <3-1> Production of Organic EL Elements

Using each of the charge transport polymers shown in Table 8, organic EL elements of Examples 1D and 2D were produced in the same manner as Example B described above.

### <4-2> Evaluation of Organic EL Elements

For each organic EL element produced above, the drive voltage and emission efficiency at a luminance of 5,000 cd/m², and the emission lifespan (luminance half-life) when the initial luminance was 5,000 cd/m² were measured. The measurement results are shown in Table 8.

**[Table 8]**

| | | Polymer evaluation | | Evaluations of organic HOD elements | | | Evaluations of organic EL elements | | |
|---|---|---|---|---|---|---|---|---|---|
| Item | Charge transport polymer | Thermal weight reduction upon heating at 300°C (% by mass) | Dissolution time | Drive voltage (V1) | Drive voltage (V2) | Increase in drive voltage (V2)-(V1) | Drive voltage (V) | Emission efficiency (cd/A) | Emission lifespan (h) |
| Example 1D | 1D | 4.9 | 6.2 minutes | 3.8 | 4.2 | 0.4 | 7.8 | 17.0 | 180 |
| Example 2D | 3D | 3.1 | 6.4 minutes | 2.8 | 2.8 | 0 | 8.0 | 17.3 | 188 |

As shown in Table 8, the results for Examples 1D and 2D indicated that the increase in the drive voltage was clearly reduced, and the conductivity was excellent. The charge transport polymers 1D and 3D exhibited little thermal weight reduction upon heating at 300°C and had excellent heat resistance. In other words, it is evident that by using a charge transport polymer having excellent heat resistance, thermal degradation of the organic layer is suppressed, meaning any deterioration in the performance of the organic layer can be suppressed. Further, in the organic EL elements of these examples, excellent results were obtained for the drive voltage, the emission efficiency and the emission lifespan.

The effects of embodiments of the present invention have been demonstrated above using a series of examples. However, the present invention is not limited to the charge transport polymers used in the above examples, and provided the scope of the present invention is not exceeded, organic electronic elements can be obtained in a similar manner even in those cases where other charge transport polymers are used. The organic electronic elements thus obtained have similar superior characteristics to each of the examples described above.

This Application is related to the subject matter disclosed in prior Japanese Application 2016-091113, PCT/JP2016/082291, prior Japanese Application 2017-050056, and prior Japanese Application 2017-039341, the entire contents of which are incorporated by reference herein.

It should be noted that, besides the embodiments already described above, various modifications and variations can be made in these embodiments without departing from the novel and advantageous features of the present invention. Accordingly, it is intended that all such modifications and variations are included within the scope of the appended claims.

### DESCRIPTION OF THE REFERENCE SIGNS

- 1:: Light-emitting layer
- 2:: Anode
- 3:: Hole injection layer
- 4:: Cathode
- 5:: Electron injection layer
- 6:: Hole transport layer
- 7:: Electron transport layer
- 8:: Substrate

## Claims

1. A charge transport material comprising a charge transport compound for which thermal weight reduction upon heating at 300°C is not more than 5% by mass.

2. The charge transport material according to Claim 1, wherein the charge transport compound is a charge transport polymer having a divalent structural unit with charge transport properties.

3. The charge transport material according to Claim 2, wherein the charge transport polymer comprises one or more structures selected from the group consisting of aromatic amine structures, carbazole structures, thiophene structures, bithiophene structures, benzene structures and fluorene structures.

4. The charge transport material according to Claim 2 or 3, wherein the charge transport polymer has at least one polymerizable functional group.

5. The charge transport material according to any one of Claims 2 to 4, wherein the charge transport polymer has a structure that branches in three or more directions.

6. The charge transport material according to Claim 1, wherein the charge transport compound comprises a charge transport compound having a structural region represented by formula (I) below:
-Ar-X-Y-Z (I)
wherein Ar represents an arylene group or heteroarylene group of 2 to 30 carbon atoms, X represents at least one type of linking group selected from the group consisting of groups of formulas (x1) to (x10) shown below, Y represents a divalent group derived from an aliphatic hydrocarbon group of 1 to 10 carbon atoms, and Z represents a substituted or unsubstituted polymerizable functional group: 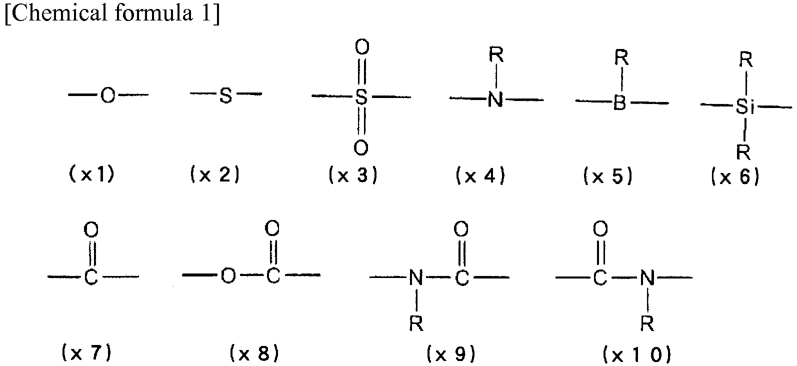 wherein each R independently represents a hydrogen atom, a linear, cyclic or branched alkyl group of 1 to 22 carbon atoms, or an aryl group or heteroaryl group of 2 to 30 carbon atoms.

7. The charge transport material according to Claim 1, wherein the charge transport compound comprises a charge transport compound having a structural region represented by formula (II) below:
-Ar-Y-Z (II)
wherein Ar represents an arylene group or heteroarylene group of 2 to 30 carbon atoms, Y represents a divalent group derived from an aliphatic hydrocarbon of 1 to 10 carbon atoms, and Z represents a substituted or unsubstituted polymerizable functional group.

8. The charge transport material according to Claim 1, wherein the charge transport compound comprises a charge transport compound having at least one structural region represented by formula (III-1), formula (III-2) or formula (III-3) shown below:
-Ar-O-(CH₂)ₐ-O-CH₂-Z (III-1)
-Ar-(CH₂)_{b}-O-CH₂-Z (III-2)
-Ar-O-(CH₂)_{c}-Z (III-3)
wherein Ar represents an arylene group or heteroarylene group of 2 to 30 carbon atoms, and a represents an integer from 1 to 6, b represents an integer from 2 to 6, c represents an integer from 2 to 6, and Z represents a substituted or unsubstituted polymerizable functional group.

9. The charge transport material according to any one of Claims 1 to 8, wherein the charge transport material is used as a hole injection material.

10. An ink composition comprising the charge transport material according to any one of Claims 1 to 8, and a solvent.

11. An organic layer formed using the charge transport material according to any one of Claims 1 to 8, or the ink composition according to Claim 7.

12. An organic electronic element having at least one organic layer according to Claim 11.

13. An organic electroluminescent element having at least one organic layer according to Claim 11.

14. The organic electroluminescent element according to Claim 13, also having a flexible substrate.

15. The organic electroluminescent element according to Claim 14, wherein the flexible substrate comprises a resin film.

16. A display element comprising the organic electroluminescent element according to any one of Claims 13 to 15.

17. An illumination device comprising the organic electroluminescent element according to any one of Claims 13 to 15.

18. A display device comprising the illumination device according to Claim 17, and a liquid crystal element as a display means.
